(19) Europäisches Patentamt
European Patent Office
Office européen des brevets

(11) EP 3 435 405 A1

(12) **EUROPEAN PATENT APPLICATION**

(43) Date of publication:
**30.01.2019 Bulletin 2019/05**

(51) Int Cl.:
***H01L 21/02*** (2006.01) ***H01L 21/67*** (2006.01)

(21) Application number: **18184897.9**

(22) Date of filing: **23.07.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.07.2017 JP 2017144597**

(71) Applicant: **SCREEN Holdings Co., Ltd.**
**Kyoto 602-8585 (JP)**

(72) Inventors:
- **Hanawa, Yosuke**
  **KYOTO-SHI, Kyoto 602-8585 (JP)**
- **Sasaki, Yuta**
  **KYOTO-SHI, Kyoto 602-8585 (JP)**

(74) Representative: **Kilian Kilian & Partner**
**Aidenbachstraße 54**
**81379 München (DE)**

# (54) SUBSTRATE TREATING METHOD AND SUBSTRATE TREATING APPARATUS

(57) Disclosed is a substrate treating method of performing dry processing on a pattern-formed surface of a substrate, the substrate treating method comprising: a supplying step of supplying a process liquid containing a sublimable substance to the pattern-formed surface of the substrate; a temperature adjusting step of adjusting a temperature of the substrate so as to control the process liquid supplied to the pattern-formed surface of the substrate within a temperature range equal to or above a melting point of the sublimable substance and below a boiling point thereof; a solidifying step of solidifying, on the pattern-formed surface, the process liquid whose temperature is adjusted so as to form a solidified body; and a sublimating step of subliming the solidified body so as to remove the solidified body from the pattern-formed surface, wherein the temperature adjusting step is performed so as to overlap at least the supplying step and is completed at least before the solidifying step is started.

F I G. 1

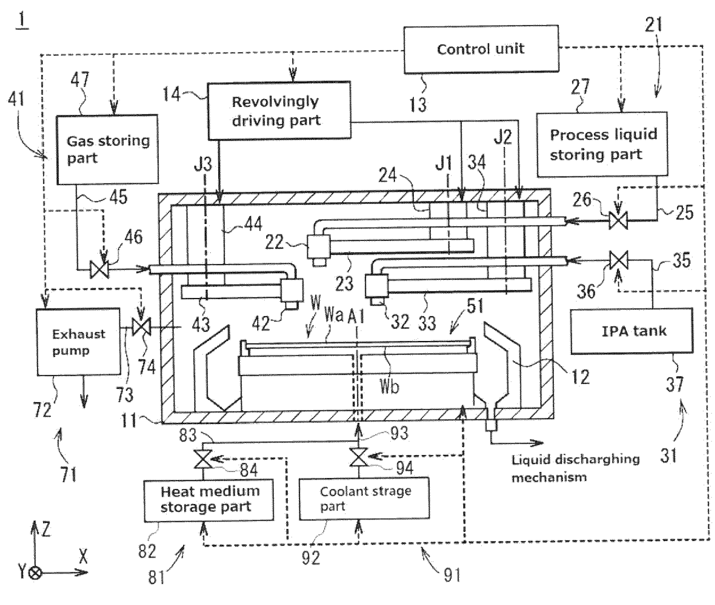




Printed by Jouve, 75001 PARIS (FR)

## Description

BACKGROUND OF THE INVENTION

FIELD OF THE INVENTION

The present invention relates to a substrate treating apparatus and a substrate treating method which remove, from substrates, liquids adhered to various types of substrates (hereinafter simply referred to as "substrates") such as a semiconductor substrate, a glass substrate for a photomask, a glass substrate for a liquid crystal display, a glass substrate for a plasma display, a FED (Field Emission Display) substrate, a substrate for an optical disc, a substrate for a magnetic disc and a substrate for a magneto-optical disc.

DESCRIPTION OF RELATED ART

In the manufacturing process of an electronic component such as a semiconductor device or a liquid crystal display device, various types of wet processing using liquids are performed on a substrate, and thereafter dry processing for removing the liquids adhered to the substrate by the wet processing is performed on the substrate.

As the wet processing, washing processing which removes contaminants on the surface of the substrate can be mentioned. For example, on the surface of a substrate in which a fine pattern having recesses and projections is formed by a dry etching step, a reaction byproduct (etching residue) is present. In addition to the etching residue, a metal impurity, an organic contaminant and the like may be adhered to the surface of the substrate, and in order to remove these substances, washing processing such as for supplying a washing liquid to the substrate is performed.

After the washing processing, rinse processing which removes the washing liquid with a rinse liquid and dry processing which dries the rinse liquid are performed. As the rinse processing, rinse processing that supplies a rinse liquid such as deionized water (DIW) to the surface of the substrate to which the washing liquid is adhered so as to remove the washing liquid on the surface of the substrate can be mentioned. Thereafter, the dry processing is performed that removes the rinse liquid so as to dry the substrate.

In recent years, as a finer pattern has been formed on a substrate, the aspect ratio of a convex portion in a pattern having recesses and projections (the ratio between the height and the width of the convex portion in the pattern) has been increased. Hence, there is a problem of a so-called pattern collapse in which at the time of dry processing, surface tension that acts on a boundary surface between a liquid such as a washing liquid or a rinse liquid entering a concave portion in the pattern and a gas in contact with the liquid pulls and collapses the adjacent convex portions in the pattern.

As a dry technology for preventing the pattern collapse caused by surface tension as described above, for example, Japanese Unexamined Patent Application Publication No. 2013-16699 discloses a method in which a solution is brought into contact with a substrate where a structure (pattern) is formed such that the solution is changed into a solid, in which the solid is used as a support member (solidified body) for the pattern and in which the support member is removed by being changed from a solid phase to a gas phase without the intervention of a liquid phase. This patent literature also discloses that as the support member, a sublimable substance is used which is at least any of a methacrylic resin material, a styrene resin material and a fluorocarbon material.

However, when as the sublimable substance disclosed in Japanese Unexamined Patent Application Publication No. 2013-16699, for example, a fluorocarbon material whose vapor pressure at room temperature is high is used, as compared with a methacrylic resin material and a styrene resin material, the fluorocarbon material shows satisfactory drying performance but it is still disadvantageously impossible to sufficiently prevent the collapse of the pattern.

BRIEF SUMMARY OF THE INVENTION

The present invention is made in view of the foregoing problem, and has an object to provide a substrate treating method and a substrate treating apparatus which can remove a liquid adhered to the surface of a substrate while preventing the collapse of a pattern formed on the surface of the substrate.

In a conventional substrate treating method, in order to prevent the formation of a solidified body having an excessively large film thickness, for example, when a process liquid is supplied, the rotation speed (the number of revolutions) of a substrate is increased, and thus an excess of the process liquid is spun off by action of centrifugal force. The inventors et al. of the present application have found a phenomenon in which when a sublimable substance such as a fluorocarbon material whose vapor pressure at room temperature is high is used, a process liquid containing the substance described above is supplied at a high rotation speed of a substrate, and thus the process liquid is solidified while being supplied, and thereby have completed the invention of the present application.

In order to solve the above-mentioned problems, the substrate treating method of the present invention comprises: a supplying step of supplying a process liquid containing a sublimable substance to the pattern-formed surface of the substrate; a temperature adjusting step of adjusting a temperature of the substrate so as to control the process liquid supplied to the pattern-formed surface of the substrate within a temperature range equal to or above a melting point of the sublimable substance and below a boiling point thereof; a solidifying step of solidifying, on the pattern-formed surface, the process liquid whose temperature is adjusted so as to form a solidified body; and a sublimating step of subliming the solidified body so as to remove the solidified body from the pattern-formed surface, wherein the temperature adjusting step is performed so as to overlap at least the supplying step and is completed at least before the solidifying step is started.

As described above, for example, when a sublimable substance such as a fluorocarbon material whose vapor pressure at room temperature is high is used, the solidification of the process liquid is started due to the generation of sublimation heat caused by the vaporization of the sublimable substance. For example, as compared with a solidification phenomenon of the process liquid in the solidifying step, a solidification phenomenon of the process liquid caused by the sublimation heat proceeds at a relatively slow speed. Hence, an internal stress (distortion) is present within the solidified body generated by the sublimation heat, and thus it is considered that the collapse of a pattern is caused by this internal stress. As the solidification of the process liquid proceeds from during the supplying step, a solidified body which is finally formed in the solidifying step has a larger film thickness. Consequently, the collapse rate of the pattern is further increased. Furthermore, as the film thickness of the solidified body is increased, a larger amount of impurities such as particles contained in the process liquid is contained in the solidified body. Consequently, on the pattern-formed surface after the sublimating step, the particles are left as a residue, and thus the pattern-formed surface is disadvantageously contaminated.

By contrast, in the invention of the present application, as in the configuration described above, when the process liquid is supplied onto the pattern-formed surface of the substrate, the temperature adjusting step is performed in order to control the temperature of the process liquid. More specifically, the temperature of the substrate is adjusted, and thus the process liquid is controlled within a range equal to or above the melting point of the sublimable substance and below the boiling point thereof. In this way, even when the sublimable substance is vaporized, and thus the process liquid attempts to be solidified due to the evaporation heat thereof, since the process liquid is controlled by the temperature adjustment of the substrate to be equal to or above the melting point of the sublimable substance, it is possible to prevent the solidification of the sublimable substance from being started during the supplying step. Consequently, it is possible to prevent the formation of a solidified body having an internal stress and the like, and thus it is possible to reduce the collapse of the pattern. The solidified body is prevented from being formed while the process liquid is being supplied to the pattern-formed surface, and thus it is possible to reduce the formation of the solidified body having an excessively large film thickness in the solidifying step. Consequently, it is also possible to prevent the collapse of the pattern caused by a large film thickness of the solidified body. Furthermore, the film thickness of the solidified body can be reduced, and thus it is possible to reduce the leaving of the particles and the like contained in the solidified body and derived from the process liquid on the pattern-formed surface as a residue after the sublimating step.

The temperature adjusting step is performed so as to overlap at least the supplying step, and thus it is possible to reduce or prevent the solidification of the process liquid which is being supplied to the pattern-formed surface. The temperature adjusting step is completed at least before the solidifying step in order not to inhibit the formation of the solidified body in the solidifying step.

Here, the "molten state" means that the sublimable substance melts fully or partially and thereby has fluidity so as to be brought into a liquid state. The "sublimable" means that a single substance, a compound or a mixture has the property of changing its phase from a solid phase to a gas phase or from a gas phase to a solid phase without the intervention of a liquid phase, and the "sublimable substance" means a substance which has the sublimable property described above. The "pattern-formed surface" means a surface of a substrate in which a concave/convex pattern is formed in an arbitrary region regardless of the surface being planar, curved or concave/convex. The "solidified body" means a material obtained by the solidification of a liquid.

In this configuration, in the sublimable substance, a vapor pressure in a liquid state at room temperature may be equal to or more than 300 Pa.

In this configuration, it is preferred that in the temperature adjusting step, a heat medium which is inert to at least the sublimable substance is brought into contact with a back surface on a side opposite to the pattern-formed surface of the substrate so as to control, through the substrate, a temperature of the process liquid supplied to the pattern-formed surface.

In the configuration described above, in the temperature adjusting step, the heat medium is brought into contact with the back surface of the substrate so as to control, through the substrate, the temperature of the process liquid supplied onto the pattern-formed surface within the range equal to or above the melting point of the sublimable substance and below the boiling point thereof. Since the heat medium is inert to at least the sublimable substance, for example, even when the heat medium is a gas and makes contact with the process liquid, it is possible to prevent the sublimable substance from being denatured.

In this configuration, it is preferred that in at least any one of the solidifying step and the sublimating step, an inert gas which has a temperature equal to or below a freezing point of the sublimable substance and which is inert to at least the sublimable substance is supplied to the pattern-formed surface of the substrate.

In the configuration described above, in the solidifying step, the inert gas having a temperature equal to or below the freezing point of the sublimable substance is supplied toward the pattern-formed surface, and thus it is possible to cool and thereby solidify the sublimable substance. In the sublimating step, the inert gas is supplied to the solidified body formed on the pattern-formed surface, and thus it is possible to sublime the solidified body. The inert gas is inert to the sublimable substance, and thus it is possible to prevent the sublimable substance from being denatured.

In this configuration, it is preferred that in at least any one of the solidifying step and the sublimating step, a coolant at a temperature equal to or below a freezing point of the sublimable substance is supplied toward a back surface on a side opposite to the pattern-formed surface of the substrate.

In the configuration described above, in the solidifying step, the coolant at a temperature equal to or below the freezing point of the sublimable substance is supplied toward the back surface on the side opposite to the pattern-formed surface of the substrate, and thus it is possible to cool and thereby solidify the sublimable substance. In the sublimating step, the coolant is supplied toward the back surface of the substrate, and thus it is possible to naturally sublime the solidified body while preventing the melting of the solidified body from the side of the back surface.

In this configuration, it is preferred that in the sublimating step, the pattern-formed surface on which the solidified body is formed in the solidifying step is reduced in pressure to an environment lower than atmospheric pressure. In this way, in at least the supplying step and the solidifying step, a configuration having pressure resistance does not need to be adopted, and thus it is possible to reduce the cost of the apparatus.

In the configuration described above, in the sublimating step, the pattern-formed surface of the substrate is reduced in pressure to an environment lower than atmospheric pressure, and thus it is possible to sublime the sublimable substance in the solidified body. Here, when the sublimable substance is sublimed from the solidified body so as to be vaporized, heat is deprived from the solidified body as sublimation heat. Thus, the solidified body is cooled. Hence, even under an environment slightly higher than the melting point of the sublimable substance, the solidified body can be maintained in the state of a temperature lower than the melting point of the sublimable substance without being additionally cooled. Consequently, it is possible to sublime the solidified body while preventing the sublimable substance from being melted in the solidified body. Since it is not necessary to additionally provide a cooling mechanism, it is possible to reduce the cost of the apparatus and the cost of the treating.

In this configuration, the temperature adjusting step may be started before start of the supplying step, at the start of the supplying step or during the supplying step, and be completed during the supplying step, at completion of the supplying step and after the completion of the supplying step.

In this configuration, it is preferred that the sublimable substance contains a fluorocarbon compound. Since in the sublimable substance containing a fluorocarbon compound, its state is changed from a solid state to a gas state without the intervention of a liquid state, a surface tension is prevented from being exerted on the pattern formed on the substrate. Consequently, it is possible to prevent the collapse of the pattern formed on the substrate. Moreover, a fluorocarbon compound which is a sublimable substance further reduces the collapse of the pattern as compared with, for example, a conventional sublimable substance such as t-butanol, and thus the fluorocarbon compound is also effective for a substrate which is finely formed and in which a pattern having a high aspect ratio is formed.

In order to solve the above-mentioned problems, the substrate treating apparatus according to the present invention includes: a supplying step of supplying a process liquid containing a sublimable substance to a pattern-formed surface of a substrate; a temperature adjusting step of adjusting a temperature of the substrate so as to control the process liquid supplied to the pattern-formed surface of the substrate within a temperature range equal to or above a melting point of the sublimable substance and below a boiling point thereof; a solidifying step of solidifying, on the pattern-formed surface, the process liquid whose temperature is adjusted so as to form a solidified body; and a sublimating step of subliming the solidified body so as to remove the solidified body from the pattern-formed surface, the temperature adjusting step is performed so as to overlap at least the supplying step and is completed at least before the solidifying step is started, the substrate treating apparatus includes: a supplying unit adapted for supplying the process liquid containing the sublimable substance to the pattern-formed surface of the substrate; a temperature adjusting unit adapted for adjusting the temperature of the substrate so as to control the process liquid supplied to the pattern-formed surface of the substrate within the temperature range equal to or above the melting point of the sublimable substance and equal to or below the boiling point thereof; a solidifying unit adapted for solidifying, on the pattern-formed surface, the process liquid whose temperature is adjusted so as to form the solidified body; and a sublimating unit adapted for subliming the solidified body so as to remove the solidified body from the pattern-formed surface and the temperature adjusting unit supplies, to a back surface on a side opposite to the pattern-formed surface of the substrate, a heat medium which has a temperature equal to or above a melting point of the sublimable substance and below a boiling point thereof and which is inert to at least the sublimable substance.

In the configuration described above, when the process liquid is supplied onto the pattern-formed surface of

the substrate, the temperature adjusting unit controls the temperature of the process liquid. More specifically, the temperature adjusting unit adjusts the temperature of the substrate so as to control the process liquid within a range equal to or above the melting point of the sublimable substance and below the boiling point thereof. In this way, even when the sublimable substance is vaporized, and thus the process liquid attempts to be solidified due to the evaporation heat thereof, since the process liquid is controlled by the temperature adjustment of the substrate to be equal to or above the melting point of the sublimable substance, it is possible to prevent the solidification of the sublimable substance from being started while being supplied by the supplying unit. Consequently, it is possible to prevent the formation of a solidified body having an internal stress and the like, and thus it is possible to reduce the collapse of the pattern. The solidified body is prevented from being formed while the process liquid is being supplied to the pattern-formed surface, and thus it is possible to reduce the formation of the solidified body having an excessively large film thickness when the process liquid is solidified by the solidifying unit. Consequently, it is also possible to prevent the collapse of the pattern caused by a large film thickness of the solidified body. Furthermore, the film thickness of the solidified body can be reduced, and thus it is possible to reduce the leaving of the particles and the like contained in the solidified body and derived from the process liquid on the pattern-formed surface as a residue after the sublimating step.

The present invention has effects described below by use of the units described above.

Specifically, in the present invention, when the process liquid containing the sublimable substance is supplied onto the pattern-formed surface of the substrate, the temperature of the substrate is adjusted, and thus the process liquid is controlled within a temperature range equal to or above the melting point of the sublimable substance and below the boiling point thereof. In this way, in the present invention, even when the sublimable substance is vaporized, and thus the process liquid attempts to be solidified due to the evaporation heat thereof, it is possible to prevent the solidification of the process liquid. Consequently, it is possible to prevent the generation of a solidified body having an internal stress, and thus it is possible to reduce the collapse of the pattern. It is also possible to prevent the formation of a solidified body having an excessively large film thickness, and thus it is possible to prevent the collapse of the pattern caused thereby. It is also possible to prevent the generation of a solidified body while the process liquid is being supplied onto the pattern-formed surface, and thus it is possible to reduce the formation of a solidified body having a large film thickness. In this way, it is possible to prevent the collapse of the pattern caused by the large film thickness of the solidified body. Furthermore, the film thickness of the solidified body is reduced, and thus it is possible to reduce the residue of particles generated on the pattern-formed surface after the sublimation. In other words, according to the present invention, it is possible to provide a substrate treating method and a substrate treating apparatus which are suitable for satisfactorily removing a liquid on a substrate by dry processing while more reducing the collapse of a pattern.

## BRIEF DESCRIPTION OF THE DRAWINGS

Fig. 1 is an illustrative diagram schematically showing a substrate treating apparatus according to a first embodiment of the present invention.

Fig. 2 is a schematic plan view showing the substrate treating apparatus.

Fig. 3 is a schematic cross-sectional view schematically showing a substrate holder in the substrate treating apparatus.

Fig. 4A is a block diagram showing a schematic configuration of a process liquid storing part in the substrate treating apparatus.

Fig. 4B is an illustrative diagram showing a specific configuration of the process liquid storing part.

Fig. 5 is a block diagram showing a schematic configuration of a gas supplying unit in the substrate treating apparatus.

Fig. 6 is a block diagram showing a schematic configuration of a temperature adjusting unit in the substrate treating apparatus.

Fig. 7 is a block diagram showing a schematic configuration of a coolant supplying unit in the substrate treating apparatus.

Fig. 8 is an illustrative diagram showing a schematic configuration of a control unit in the substrate treating apparatus.

Fig. 9 is a flowchart showing a substrate treating method using the substrate treating apparatus.

Fig. 10 is a diagram showing the state of a substrate in the individual steps of the substrate treating method.

Fig. 11A is a schematic view showing the states of a supplying step and a temperature adjusting step for the process liquid in the substrate treating method.

Fig. 11B is a schematic view showing the state of a solidifying step for the process liquid.

Fig. 11C is a schematic view showing a state where a solidified body is formed.

Fig. 12 is a flowchart showing a substrate treating method according to a second embodiment of the present invention.

Fig. 13 is a diagram showing the state of the substrate in the individual steps of the substrate treating method according to the second embodiment.

Fig. 14 is an SEM image showing a pattern-formed surface of an unprocessed silicon substrate used in examples of the present invention.

Fig. 15 is an SEM image showing a pattern-formed surface of a silicon substrate on which substrate processing in example 1 of the present invention is performed.

DETAILED DESCRIPTION OF THE INVENTION

(First embodiment)

A first embodiment of the present invention will be described below.

A substrate treating apparatus according to the present embodiment can be used, for example, for processing on various types of substrates. The "substrates" described above refer to various types of substrates such as a semiconductor substrate, a glass substrate for a photomask, a glass substrate for a liquid crystal display, a glass substrate for a plasma display, a FED (Field Emission Display) substrate, a substrate for an optical disc, a substrate for a magnetic disc and a substrate for a magneto-optical disc. In the present embodiment, a description will be given using, as an example, a case where the substrate treating apparatus 1 is used for processing on a semiconductor substrate (hereinafter referred to as a "substrate").

As an example of the substrate, a substrate is used in which a circuit pattern and the like (hereinafter referred to as a "pattern") are formed on only one main surface. Here, a pattern-formed surface (main surface) on which the pattern is formed is referred to as a "front surface", and a main surface on the opposite side on which the pattern is not formed is referred to as a "back surface". The surface of the substrate which is directed downward is referred to as a "lower surface", and the surface of the substrate which is directed upward is referred to as an "upper surface". A description will be given below with the assumption that the upper surface is the front surface.

The substrate treating apparatus is a single-wafer type substrate treating apparatus which is used in washing processing (including rinse processing) for removing contaminants such as particles adhered to the substrate and dry processing after the washing processing.

<1-1 Configuration of substrate treating apparatus>

The configuration of the substrate treating apparatus according to the present embodiment will first be described with reference to Figs. 1 to 3.

Fig. 1 is an illustrative diagram schematically showing the substrate treating apparatus according to the present embodiment. Fig. 2 is a schematic plan view showing the internal configuration of the substrate treating apparatus. Fig. 3 is a schematic cross-sectional view schematically showing a substrate holder in the substrate treating apparatus. In individual figures, in order to clarify the relationship of directions shown in the figures, XYZ orthogonal coordinate axes are shown as necessary. In Figs. 1 and 2, an XY plane indicates a horizontal plane, and a + Z direction indicates a vertically upward direction.

As shown in Fig. 1, the substrate treating apparatus 1 includes at least a chamber 11 which is a container for storing the substrate W, a substrate holder 51 which holds the substrate W, a control unit 13 which controls the individual portions of the substrate treating apparatus 1, a process liquid supplying unit (supplying unit) 21 which supplies a process liquid to the front surface Wa of the substrate W, an IPA supplying unit 31 which supplies IPA to the front surface Wa of the substrate W, a gas supplying unit (solidifying unit, sublimating unit) 41 which supplies a gas to the front surface Wa of the substrate W, a scattering prevention cup 12 which collects the IPA, the process liquid and the like, a revolvingly driving part 14 which individually and independently turns and drives arms to be described later, a pressure reducing unit (sublimating unit) 71 which reduces the pressure within the chamber 11, a temperature adjusting unit 81 which controls the temperature of the process liquid within a predetermined range and a coolant supplying unit (solidifying unit, sublimating unit) 91 which supplies a coolant to the back surface Wb of the substrate W. The substrate treating apparatus 1 also includes a substrate carrying-in/out unit, a chuck pin opening/closing mechanism and a wet washing unit (all of which are not illustrated). The individual portions of the substrate treating apparatus 1 will be described below. Although in Figs. 1 and 2, only portions used in the dry processing are shown and a washing nozzle and the like used in the washing processing are not shown, the substrate treating apparatus 1 may include the nozzle and the like.

The substrate holder 51 is a unit which holds the substrate W, and, as shown in Fig. 3, holds the substrate W in a substantially horizontal posture in a state where the front surface Wa of the substrate is directed upward and rotates the substrate W. The substrate holder 51 includes a spin chuck 55 in which a spin base 53 and a rotation support shaft 57 are integrally coupled. The spin base 53 is formed substantially in the shape of a circle in plain view, and the hollow rotation support shaft 57 which is extended in a substantially vertical direction is fixed to the center portion thereof. The rotation support shaft 57 is coupled to the rotation shaft of a chuck rotation mechanism 56 which includes a motor. The chuck rotation mechanism 56 is stored within a cylindrical casing 52, and the rotation support shaft 57 is supported by

the casing 52 so as to be freely rotated about the rotation shaft in the vertical direction.

The chuck rotation mechanism 56 rotates the rotation support shaft 57 about the rotation shaft by drive from a chuck drive portion (unillustrated) in the control unit 13. In this way, the spin base 53 attached to an upper end portion of the rotation support shaft 57 is rotated about the rotation shaft. The control unit 13 controls the chuck rotation mechanism 56 through the chuck drive portion, and thereby can adjust the rotation speed of the spin base 53.

In the vicinity of the peripheral portion of the spin base 53, a plurality of chuck pins 54 for grasping the peripheral end portion of the substrate W are provided so as to stand. Although the number of chuck pins 54 installed is not particularly limited, at least three or more chuck pins 54 are preferably provided in order to reliably hold the circular substrate W. In the present embodiment, along the peripheral portion of the spin base 53, three chuck pins 54 are arranged at equal intervals (see Fig. 2). Each of the chuck pins 54 includes a substrate support pin which supports the peripheral portion of the substrate W from below and a substrate hold pin which presses the outer circumferential end surface of the substrate W supported by the substrate support pin so as to hold the substrate W.

Each of the chuck pins 54 can be switched between a pressed state where the substrate hold pin presses the outer circumferential end surface of the substrate W and a released state where the substrate hold pin is separated from the outer circumferential end surface of the substrate W, and the switching of the states is performed according to an operation instruction from the control unit 13 which controls the entire device. More specifically, when the substrate W is loaded or unloaded with respect to the spin base 53, the individual chuck pins 54 are brought into the released state whereas when substrate processing to be described later from the washing processing to sublimation processing is performed on the substrate W, the individual chuck pins 54 are brought into the pressed state. When the chuck pin 54 is brought into the pressed state, the chuck pin 54 grasps the peripheral portion of the substrate W such that the substrate W is held in a horizontal posture (XY plane) a predetermined distance apart from the spin base 53. In this way, the substrate W is held horizontally in a state where its front surface Wa is directed upward. A method of holding the substrate W is not limited to this method, and for example, the back surface Wb of the substrate W may be held by an adsorption method with a spin chuck or the like.

In a state where the substrate W is held by the spin chuck 55, more specifically, in a state where the peripheral portion of the substrate W is held by the chuck pins 54 provided on the spin base 53, the chuck rotation mechanism 56 is operated, and thus the substrate W is rotated about the rotation shaft A1 in the vertical direction.

The process liquid supplying unit (supplying unit) 21 is a unit which supplies the process liquid (dry assistant liquid) to the pattern-formed surface of the substrate W held in the substrate holder 51, and includes, as shown in Fig. 1, at least a nozzle 22, an arm 23, a turning shaft 24, a pipe 25, a valve 26 and a process liquid storing part 27.

As shown in Figs. 4A and 4B, the process liquid storing part 27 includes at least a process liquid storing tank 271, an agitation part 277 which agitates the process liquid within the process liquid storing tank 271, a pressurization part 274 which pressurizes the process liquid storing tank 271 so as to feed out the process liquid and a temperature adjusting part 272 which heats the process liquid within the process liquid storing tank 271. Fig. 4A is a block diagram showing a schematic configuration of the process liquid storing part 27, and Fig. 4B is an illustrative diagram showing a specific configuration of the process liquid storing part 27.

The agitation part 277 includes a rotation part 279 which agitates the process liquid within the process liquid storing tank 271 and an agitation control part 278 which controls the rotation of the rotation part 279. The agitation control part 278 is electrically connected to the control unit 13. The rotation part 279 has a propeller-shaped agitation blade at a tip end of the rotation shaft (the lower end of the rotation part 279 in Fig. 4B), the control unit 13 provides an operation instruction to the agitation control part 278 such that the rotation part 279 is rotated, and thus the process liquid is agitated by the agitation blade, with the result that the concentration and temperature of a dry auxiliary substance and the like in the process liquid are made uniform.

The method of making the concentration and temperature of the process liquid within the process liquid storing tank 271 uniform is not limited to the method described above, and a known method such as a method of additionally providing a circulation pump to circulate the process liquid can be used.

The pressurization part 274 is formed with a nitrogen gas tank 275 which is the supply source of a gas for pressurizing the interior of the process liquid storing tank 271, a pump 276 which pressurizes nitrogen gas and a pipe 273. The nitrogen gas tank 275 is connected through the pipe 273 with the pipeline to the process liquid storing tank 271, and the pump 276 is interposed in the pipe 273.

The temperature adjusting part 272 is electrically connected to the control unit 13, and heats, by the operation instruction of the control unit 13, the process liquid stored in the process liquid storing tank 271 so as to perform temperature adjustment. The temperature adjustment is preferably performed such that the temperature of the process liquid is equal to or above the melting point of the sublimable substance (dry auxiliary substance the details of which will be described later) contained in the process liquid. In this way, when the process liquid contains a sublimable substance in a molten state, it is possible to maintain the molten state of the sublimable substance. The upper limit of the temperature adjustment is preferably a temperature which is lower than the boiling point. The temperature adjusting part 272 is not particularly limited, and for example, a known temperature adjustment mechanism can be used such as a resistance

heater, a Peltier element or a pipe through which water whose temperature is adjusted is passed. In the present embodiment, the configuration of the temperature adjusting part 272 is arbitrary. For example, when the process liquid contains a sublimable substance in a molten state, and an environment in which the substrate treating apparatus 1 is installed is an environment whose temperature is higher than the melting point of the sublimable substance, since it is possible to maintain the molten state of the sublimable substance, it is not necessary to heat the process liquid. Consequently, the temperature adjusting part 272 can be omitted.

The process liquid storing part 27 (more specifically, the process liquid storing tank 271) is connected through the pipe 25 with the pipeline to the nozzle 22, and the valve 26 is interposed partway through the path of the pipe 25.

An air pressure sensor (unillustrated) is provided within the process liquid storing tank 271, and is electrically connected to the control unit 13. The control unit 13 controls, based on a value detected by the air pressure sensor, the operation of the pump 276 so as to keep the air pressure within the process liquid storing tank 271 at a predetermined air pressure higher than atmospheric pressure. On the other hand, the valve 26 is also electrically connected to the control unit 13, and is normally closed. The opening and closing of the valve 26 is also controlled by the operation instruction of the control unit 13. When the control unit 13 provides the operation instruction to the process liquid supplying unit 21 so as to open the valve 26, the process liquid is fed by pressure from the interior of the process liquid storing tank 271 which is pressurized, and is discharged through the pipe 25 from the nozzle 22. In this way, it is possible to supply the process liquid to the front surface Wa of the substrate W. Since the process liquid storing tank 271 uses, as described above, the pressure caused by the nitrogen gas to feed the process liquid, the process liquid storing tank 271 is preferably configured so as to be airtight.

The nozzle 22 is attached to the tip end portion of the arm 23 which is provided so as to be extended horizontally, and is arranged above the spin base 53. The back end portion of the arm 23 is supported by the turning shaft 24 provided so as to be extended in the Z direction such that the back end portion of the arm 23 is freely rotated about an axis J1, and the turning shaft 24 is provided so as to be fixed within the chamber 11. The arm 23 is coupled through the turning shaft 24 to the revolvingly driving part 14. The revolvingly driving part 14 is electrically connected to the control unit 13, and turns the arm 23 about the axis J1 by the operation instruction from the control unit 13. As the arm 23 is turned, the nozzle 22 is also moved.

As indicated by solid lines in Fig. 2, the nozzle 22 is normally located outside the peripheral portion of the substrate W, and is arranged in a retraction position P1 outside the scattering prevention cup 12. When the arm 23 is turned by the operation instruction of the control unit 13, the nozzle 22 is moved along the path of an arrow AR1 so as to be arranged in a position above the center portion (the axis A1 or the vicinity thereof) of the front surface Wa of the substrate W.

As shown in Fig. 1, the IPA supplying unit 31 is a unit which supplies the IPA (isopropyl alcohol) to the substrate W held in the substrate holder 51, and includes a nozzle 32, an arm 33, a turning shaft 34, a pipe 35, a valve 36 and an IPA tank 37.

The IPA tank 37 is connected through the pipe 35 with the pipeline to the nozzle 32, and the valve 36 is interposed partway through the path of the pipe 35. In the IPA tank 37, the IPA is stored, the IPA within the IPA tank 37 is pressurized by an unillustrated pump and thus the IPA is fed from the pipe 35 in the direction of the nozzle 32.

The valve 36 is electrically connected to the control unit 13, and is normally closed. The opening and closing of the valve 36 is controlled by the operation instruction of the control unit 13. When the valve 36 is opened by the operation instruction of the control unit 13, the IPA is passed through the pipe 35 and is supplied from the nozzle 32 to the front surface Wa of the substrate W.

The nozzle 32 is attached to the tip end portion of the arm 33 which is provided so as to be extended horizontally, and is arranged above the spin base 53. The back end portion of the arm 33 is supported by the turning shaft 34 provided so as to be extended in the Z direction such that the back end portion of the arm 33 is freely rotated about an axis J2, and the turning shaft 34 is provided so as to be fixed within the chamber 11. The arm 33 is coupled through the turning shaft 34 to the revolvingly driving part 14. The revolvingly driving part 14 is electrically connected to the control unit 13, and turns the arm 33 about the axis J2 by the operation instruction from the control unit 13. As the arm 33 is turned, the nozzle 32 is also moved.

As indicated by solid lines in Fig. 2, the nozzle 32 is normally located outside the peripheral portion of the substrate W, and is arranged in a retraction position P2 outside the scattering prevention cup 12. When the arm 33 is turned by the operation instruction of the control unit 13, the nozzle 32 is moved along the path of an arrow AR2 so as to be arranged in a position above the center portion (the axis A1 or the vicinity thereof) of the front surface Wa of the substrate W.

Although in the present embodiment, IPA is used in the IPA supplying unit 31, as long as a liquid is used which is soluble in the sublimable substance and deionized water (DIW), in the present invention, there is no limitation to IPA. Examples of a replacement of the IPA in the present embodiment include methanol, ethanol, acetone, benzene, carbon tetrachloride, chloroform, hexane, decalin, tetralin, acetic acid, cyclohexanol, ether and hydrofluoroether (Hydro Fluoro Ether).

As shown in Fig. 1, the gas supplying unit 41 is a unit which supplies a gas to the substrate W held in the substrate holder 51, and includes a nozzle 42, an arm 43, a turning shaft 44, a pipe 45, a valve 46 and a gas storing part 47.

As shown in Fig. 5, the gas storing part 47 includes a gas tank 471 which stores a gas and a gas temperature adjusting part 472 which adjusts the temperature of the gas stored in the gas tank 471. This figure is a block diagram showing a schematic configuration of the gas storing part 47. The gas temperature adjusting part 472 is electrically connected to the control unit 13, and heats or cools the gas stored in the gas tank 471 by the operation instruction of the control unit 13 so as to perform temperature adjustment. The temperature adjustment is preferably performed such that the gas stored in the gas tank 471 has a low temperature which is equal to or below the freezing point of the sublimable substance. The gas temperature adjusting part 472 is not particularly limited, and for example, a known temperature adjustment mechanism can be used such as a Peltier element or a pipe through which water whose temperature is adjusted is passed.

As shown in Fig. 1, the gas storing part 47 (more specifically, the gas tank 471) is connected through the pipe 45 with the pipeline to the nozzle 42, and the valve 46 is interposed partway through the path of the pipe 45. The gas within the gas storing part 47 is pressurized by an unillustrated pressurization unit so as to be fed to the pipe 45. Since the pressurization unit can be realized by pressurization with a pump or the like or by compressing and storing the gas into the gas storing part 47, any pressurization unit may be used.

The valve 46 is electrically connected to the control unit 13, and is normally closed. The opening and closing of the valve 46 is controlled by the operation instruction of the control unit 13. When the valve 46 is opened by the operation instruction of the control unit 13, the gas is passed through the pipe 45 and is supplied from the nozzle 42 to the front surface Wa of the substrate W.

The nozzle 42 is attached to the tip end portion of the arm 43 which is provided so as to be extended horizontally, and is arranged above the spin base 53. The back end portion of the arm 43 is supported by the turning shaft 44 provided so as to be extended in the Z direction such that the back end portion of the arm 43 is freely rotated about an axis J3, and the turning shaft 44 is provided so as to be fixed within the chamber 11. The arm 43 is coupled through the turning shaft 44 to the revolvingly driving part 14. The revolvingly driving part 14 is electrically connected to the control unit 13, and turns the arm 43 about the axis J3 by the operation instruction from the control unit 13. As the arm 43 is turned, the nozzle 42 is also moved.

As indicated by solid lines in Fig. 2, the nozzle 42 is normally located outside the peripheral portion of the substrate W, and is arranged in a retraction position P3 outside the scattering prevention cup 12. When the arm 43 is turned by the operation instruction of the control unit 13, the nozzle 42 is moved along the path of an arrow AR3 so as to be arranged in a position above the center portion (the axis A1 or the vicinity thereof) of the front surface Wa of the substrate W. How the nozzle 42 is arranged in the position above the center portion of the front surface Wa is indicated by dotted lines in Fig. 2.

In the gas tank 471, an inert gas which is inert to at least the sublimable substance, more specifically, nitrogen gas, is stored. The nitrogen gas stored is adjusted in the gas temperature adjusting part 472 such that its temperature is equal to or below the freezing point of the sublimable substance. The temperature of the nitrogen gas is not particularly limited as long as the temperature is equal to or below the freezing point of the sublimable substance, and the temperature of the nitrogen gas can be normally set within a range equal to or more than 0°C and equal to or less than 15°C. The temperature of the nitrogen gas is set equal to or more than 0°C, and thus it is possible to prevent water vapor present within the chamber 11 from being solidified and adhered to the front surface Wa of the substrate W, with the result that it is possible to prevent the substrate W from being adversely affected.

The nitrogen gas used in the present embodiment is preferably a dry gas whose dew point is equal to or less than 0°C. When the nitrogen gas is sprayed to a solidified body under an atmospheric pressure environment, the sublimable substance in the solidified body is sublimed into the nitrogen gas. Since the nitrogen gas is continuously supplied to the solidified body, the partial pressure of the sublimable substance in a gaseous state produced by the sublimation in the nitrogen gas is kept lower than the saturated vapor pressure of the sublimable substance in the gaseous state at the temperature of the nitrogen gas, and thus at least the surface of the solidified body is filled under an atmosphere in which the sublimable substance in the gaseous state is present at the saturated vapor pressure or less.

Although in the present embodiment, as the gas supplied by the gas supplying unit 41, nitrogen gas is used, as long as the gas is inert to the sublimable substance, there is no limitation to the gas in the practice of the present invention. Examples of a replacement of the nitrogen gas in the first embodiment include argon gas, helium gas and air (a gas having a nitrogen gas concentration of 80% and an oxygen gas concentration of 20%). Alternatively, a mixture gas obtained by mixing a plurality of types of gases described above may be used.

As shown in Fig. 1, the pressure reducing unit 71 is a means which reduces the interior of the chamber 11 in pressure to an environment lower than atmospheric pressure, and includes an exhaust pump 72, a pipe 73 and a valve 74. The exhaust pump 72 is a known pump which is connected through the pipe 73 with the pipeline to the chamber 11 and which applies pressure to the gas. The exhaust pump 72 is electrically connected to the control unit 13, and is normally in a stop state. The drive of the exhaust pump 72 is controlled by the operation instruction of the control unit

13. The valve 74 is interposed in the pipe 73. The valve 74 is electrically connected to the control unit 13, and is normally closed. The opening and closing of the valve 74 is controlled by the operation instruction of the control unit 13.

When the exhaust pump 72 is driven by the operation instruction of the control unit 13, and the valve 74 is opened, the gas present within the chamber 11 is exhausted by the exhaust pump 72 through the pipe 73 to the outside of the chamber 11.

The scattering prevention cup 12 is provided so as to surround the spin base 53. The scattering prevention cup 12 is connected to an unillustrated raising/lowering mechanism so as to be able to be raised and lowered in the Z direction. When the process liquid and the IPA are supplied to the pattern-formed surface of the substrate W, the scattering prevention cup 12 is located by the raising/lowering mechanism in a predetermined position as shown in Fig. 1 so as to surround, from lateral positions, the substrate W held by the chuck pins 54. In this way, it is possible to collect liquids such as the process liquid and the IPA scattered from the substrate W and the spin base 53.

The temperature adjusting unit 81 is a unit which controls the temperature of the process liquid supplied to the front surface Wa of the substrate W, and includes, as shown in Figs. 1, 3 and 6, at least a heat medium storage part 82, a pipe 83, a valve 84 and a heat medium supply part 85. Fig. 6 is a block diagram showing a schematic configuration of the heat medium storage part 82.

As shown in Fig. 6, the heat medium storage part 82 includes a heat medium tank 821 which stores the heat medium and a heat medium temperature adjusting part 822 which adjusts the temperature of the heat medium stored in the heat medium tank 821.

The heat medium temperature adjusting part 822 is electrically connected to the control unit 13, and heats or cools the heat medium stored in the heat medium tank 821 by the operation instruction of the control unit 13 so as to perform temperature adjustment. The temperature adjustment is preferably performed such that the heat medium stored in the heat medium tank 821 is within a temperature range equal to or above the melting point of the sublimable substance and below the boiling point thereof. The heat medium temperature adjusting part 822 is not particularly limited, and for example, a known temperature adjustment mechanism can be used such as a chiller using a Peltier element or a pipe through which water whose temperature is adjusted is passed.

The heat medium storage part 82 is connected through the pipe 83 with the pipeline to a supply pipe 852 to be described later, and the valve 84 is interposed partway through the path of the pipe 83. The heat medium within the heat medium storage part 82 is pressurized by an unillustrated pressurization unit so as to be fed to the pipe 83. Since the pressurization unit can be realized by pressurization with a pump or the like or by compressing and storing the gas into the heat medium storage part 82, any pressurization unit may be used.

The valve 84 is electrically connected to the control unit 13, and is normally closed. The opening and closing of the valve 84 is controlled by the operation instruction of the control unit 13. When the valve 84 is opened by the operation instruction of the control unit 13, the heat medium is passed through the pipe 83 and the supply pipe 852 and is supplied to the back surface Wb of the substrate W.

The heat medium supply part 85 is provided below the substrate W supported by the spin chuck 55 in a horizontal posture. As shown in Fig. 3, the heat medium supply part 85 includes at least an opposite member 851 whose horizontal upper surface is arranged opposite the lower surface Wb of the substrate, the supply pipe 852 which is attached to the center portion of the opposite member 851 and which is extended downward in the vertical direction and a discharge portion 853 which discharges the heat medium in a fluid state toward the back surface Wb of the substrate W.

The opposite member 851 has a disc-shaped external form whose area is smaller than the substrate W. The opposite member 851 is provided so as to be separated only an arbitrary distance apart from the substrate W. The separation distance between the opposite member 851 and the substrate W is not particularly limited, and is preferably set as necessary so as to be filled with the heat medium.

The supply pipe 852 is inserted through the center portion of the hollow rotation support shaft 57. The discharge portion 853 is opened, in the supply pipe 852, toward the center portion Cb of the lower surface Wb of the substrate, and discharges the heat medium supplied from the heat medium storage part 82 toward the lower surface Wb of the substrate. The area of the opening of the discharge portion 853 is not particularly limited, and can be set as necessary with consideration given to the discharged amount and the like. The supply pipe 852 is not connected to the rotation support shaft 57, and thus even when the spin chuck 55 is rotated, the discharge portion 853 is prevented from being rotated. The supply pipe 852 has, as will be described later, the function of supplying a coolant for cooling the back surface Wb of the substrate W, and the discharge portion 853 has the function of discharging the coolant.

The heat medium is not particularly limited as long as the heat medium is a liquid or a gas whose melting point is equal to or above that of the sublimable substance and whose boiling point is equal to or below that of the sublimable substance and has no activity against the sublimable substance. For example, as the liquid, water and the like can be mentioned. For example, as the gas, an inert gas such as nitrogen gas and the like can be mentioned.

The coolant supplying unit 91 is a unit which supplies the coolant to the back surface Wb of the substrate W, and forms parts of the solidifying unit and the sublimating unit in the present invention. More specifically, as shown in Fig. 1, the coolant supplying unit 91 includes at least a coolant storage part 92, a pipe 93 and a valve 94.

As shown in Fig. 7, the coolant storage part 92 includes a coolant tank 921 in which the coolant is stored and a coolant temperature adjusting part 922 which adjusts the temperature of the coolant stored in the coolant tank 921. Fig. 7 is a block diagram showing a schematic configuration of the coolant storage part 92.

The coolant temperature adjusting part 922 is electrically connected to the control unit 13, and heats or cools the coolant stored in the coolant tank 921 by the operation instruction of the control unit 13 so as to perform temperature adjustment. The temperature adjustment is preferably performed such that the coolant stored in the coolant tank 921 has a low temperature which is equal to or below the freezing point of the sublimable substance. The coolant temperature adjusting part 922 is not particularly limited, and for example, a known temperature adjustment mechanism can be used such as a chiller using a Peltier element or a pipe through which water whose temperature is adjusted is passed.

The coolant storage part 92 is connected through the pipe 93 with the pipeline to the supply pipe 852, and the valve 94 is interposed partway through the path of the pipe 93. The coolant within the coolant storage part 92 is pressurized by an unillustrated pressurization unit so as to be fed to the pipe 93. Since the pressurization unit can be realized by pressurization with a pump or the like or by compressing and storing the gas into the coolant storage part 92, any pressurization unit may be used. Another supply pipe for supplying the coolant to the back surface Wb of the substrate W may be provided separately of the supply pipe 852. In this case, a discharge portion for discharging the coolant is also preferably provided in the supply pipe.

The valve 94 is electrically connected to the control unit 13, and is normally closed. The opening and closing of the valve 94 is controlled by the operation instruction of the control unit 13. When the valve 94 is opened by the operation instruction of the control unit 13, the coolant is supplied through the pipe 93 and the supply pipe 852 to the back surface Wb of the substrate W.

As the coolant, a liquid or a gas whose temperature is equal to or below the freezing point of the sublimable substance can be mentioned. Furthermore, the liquid is not particularly limited, and for example, cold water having a temperature of 7°C or the like can be mentioned. The gas is not particularly limited, and for example, an inert gas which is inert to the sublimable substance, more specifically, nitrogen gas having a temperature of 7°C or the like can be mentioned.

The control unit 13 is electrically connected to the individual portions of the substrate treating apparatus 1 (see Fig. 1), and controls the operations of the individual portions. As shown in Fig. 8, the control unit 13 is formed with a computer which includes a computation processing part 15 and a memory 17. Fig. 8 is a schematic view showing the configuration of the control unit 13. As the computation processing part 15, a CPU which performs various types of computation processing is used. The memory 17 includes a ROM which is a read-only memory for storing basic programs, a RAM which is a readable and writable memory for storing various types of information and a magnetic disc for storing control software, data or the like. In the magnetic disc, substrate processing conditions (recipes) corresponding to the substrate W are previously stored. The CPU reads the substrate processing conditions on the RAM so as to control the individual portions of the substrate treating apparatus 1 according to the details thereof.

<1-2 Process liquid>

Next, the process liquid used in the present embodiment will be described below.

The process liquid of the present embodiment contains the sublimable substance (dry auxiliary substance), and, in dry processing for removing the liquid present on the pattern-formed surface of the substrate, functions as a dry assistant liquid for assisting the dry processing.

The sublimable substance has the property of changing its phase from a solid phase to a gas phase or from a gas phase to a solid phase without the intervention of a liquid phase, and in a liquid state, the vapor pressure thereof at room temperature is preferably 300 Pa or more. In the present specification, the "room temperature" described above means being in a temperature range of 5 to 35°C.

The sublimable substance contained in the process liquid may be a sublimable substance which is contained in a molten state or may be a sublimable substance which is dissolved in a solvent as a dissolved substance. Alternatively, the process liquid may be formed of a sublimable substance in a molten state. Here, the "molten state" means that the sublimable substance is molten either completely or partially so as to have fluidity and that thus the sublimable substance is in a liquid state.

The sublimable substance is not particularly limited, and examples thereof include hexamethylenetetramine, 1,3,5-trioxane, ammonium 1-pyrrolidinecarbodithioate, meta-aldehyde, paraffin (CnH2 n + 2 (n: 20 to 48)), t-butanol, paradichlorobenzene, naphthalene, L-menthol and a fluorocarbon compound.

When a sublimable substance in a molten state is mixed with a solvent, the solvent is preferably compatible with the sublimable substance in a molten state. When a sublimable substance is dissolved as a dissolved substance, the solvent preferably has dissolubility with the sublimable substance. Specifically, for example, at least one type can be mentioned which is selected from a group consisting of pure water, DIW, aliphatic hydrocarbon, aromatic hydrocarbon, ester, alcohol and ether. More specifically, at least one type can be mentioned which is selected from a group consisting

of pure water, DIW, methanol, ethanol, IPA, butanol, ethylene glycol, propylene glycol, NMP, DMF, DMA, DMSO, hexane, toluene, PGMEA (propylene glycol monomethyl ether acetate), PGME (propylene glycol monomethyl ether), PGPE (propylene glycol monopropyl ether), PGEE (propylene glycol monoethyl ether), GBL, acetylacetone, 3-pentanone, 2-heptanone, ethyl lactate, cyclohexanone, dibutyl ether, HFE (hydrofluoroether), ethyl nonafluoroisobutyl ether, ethyl nonafluorobutyl ether and m-xylene hexafluoride.

The content of the sublimable substance in the process liquid is not particularly limited, and can be set as necessary.

Here, the fluorocarbon compound is a compound in which a fluoro group is bonded to a carbon compound as a substituent. When the fluorocarbon compound is used as the sublimable substance, the fluorocarbon compound in a molten state is contained in the process liquid. The process liquid may be formed of only the fluorocarbon compound in a molten state or may further include an organic solvent. In this case, the content of the sublimable substance (fluorocarbon compound) is preferably equal to or more than 60 mass % and is more preferably equal to or more than 95 mass % with respect to the total mass of the process liquid. As long as the organic solvent is compatible with the sublimable substance in a molten state, the organic solvent is not particularly limited. Specifically, for example, alcohols and the like can be mentioned.

Specifically, for example, the fluorocarbon compound is preferably at least any one of compounds (A) to (E) below. These compounds can be used singly or can be used by combining some of them.

Compound (A): a fluoroalkane having 3 to 6 carbon atoms, or the fluoroalkane to which a substituent is bonded;
Compound (B): a fluorocycloalkane having 3 to 6 carbon atoms, or the fluorocycloalkane to which a substituent is bonded;
Compound (C): a fluorobicycloalkane having 10 carbon atoms, or the fluorobicycloalkane to which a substituent is bonded;
Compound (D): a fluorotetracyanoquinodimetane, or the fluorotetracyanoquinodimetane to which a substituent is bonded; and
Compound (E): a fluorocyclotriphosphazene, or the fluorocyclotriphosphazene to which a substituent is bonded.

[Compound (A)]

The compound (A) may be a fluoroalkane having 3 to 6 carbon atoms and represented by the general formula (1):

$$C_mH_nF_{2m+2-n} \qquad (1)$$

(where m represents an integer equal to or more than 3 and equal to or less than 6, n represents an integer equal to or more than 0 and 2m + 2 - n ≥ 1 holds true.)

More specific examples of the fluoroalkane having 3 carbon atoms include $CF_3CF_2CF_3$, $CHF_2CF_2CF_3$, $CH_2FCF_2CF_3$, $CH_3CF_2CH_3$, $CHF_2CF_2CH_3$, $CH_2FCF_2CH_3$, $CH_2FCF_2CH_2F$, $CHF_2CF_2CHF_2$, $CF_3CHFCF_3$, $CH_2FCHFCF_3$, $CHF_2CHFCF_3$, $CH_2FCHFCH_2F$, $CHF_2CHFCHF_2$, $CH_3CHFCH_3$, $CH_2FCHFCH_3$, $CHF_2CHFCH_3$, $CF_3CH_2CF_3$, $CH_2FCH_2CF_3$, $CHF_2CH_2CF_3$, $CH_2FCH_2CH_2F$, $CH_2FCH_2CHF_2$, $CHF_2CH_2CHF_2$, $CH_3CH_2CH_2F$, and $CH_3CH_2CHF_2$.

Examples of the fluoroalkane having 4 carbon atoms include $CF_3(CF_2)_2CF_3$, $CF_3(CF_2)_2CH_2F$, $CF_3CF_2CH_2CF_3$, $CHF_2(CF_2)_2CHF_2$, $CHF_2CHFCF_2CHF_2$, $CF_3CH_2CF_2CHF_2$, $CF_3CHFCH_2CF_3$, $CHF_2CHFCHFCHF_2$, $CF_3CH_2CF_2CH_3$, $CF_3CF_2CH_2CH_3$, $CF_3CHFCF_2CH_3$, and $CHF_2CH_2CF_2CH_3$.

Examples of the fluoroalkane having 5 carbon atoms include $CF_3(CF_2)_3CF_3$, $CF_3CF_2CF_2CHFCF_3$, $CHF_2(CF_2)_3CF_3$, $CHF_2(CF_2)_3CHF_2$, $CF_3CH(CF_3)CH_2CF_3$, $CF_3CHFCF_2CH_2CF_3$, $CF_3CF(CF_3)CH_2CHF_2$, $CHF_2CHFCF_2CHFCHF_2$, $CF_3CH_2CF_2CH_2CF_3$, $CHF_2(CF_2)_2CHFCH_3$, $CHF_2CH_2CF_2CH_2CHF_2$, and $CF_3(CH_2)_3CF_3$, $CF_3CHFCHFCF_2CF_3$.

Examples of the fluoroalkane having 6 carbon atoms include $CF_3(CF_2)_4CF_3$, $CF_3(CF_2)_4CHF_2$, $CF_3(CF_2)_4CH_2F$, $CF_3CH(CF_3)CHFCF_2CF_3$, $CHF_2(CF_2)_4CHF_2$, $CF_3CF_2CH_2CH(CF_3)CF_3$, $CF_3CF_2(CH_2)_2CF_2CF_3$, $CF_3CH_2(CF_2)_2CH_2CF_3$, $CF_3(CF_2)_3CH_2CF_3$, $CF_3CH(CF_3)(CH_2)_2CF_3$, $CHF_2CF_2(CH_2)_2CF_2CHF_2$, $CF_3(CF_2)_2(CH_2)_2CH_3$.

The compound (A) may be the fluoroalkane, which has 3 to 6 carbon atoms, to which a substituent is bonded. The substituent may be at least one selected from the group consisting of halogen groups other than a fluoro group (specifically, chloro, bromo and iodo groups), a hydroxyl group, an oxygen atom, alkyl groups, a carboxyl group, and perfluoroalkyl groups.

Examples of the alkyl group include methyl, ethyl, n-propyl, isopropyl, n-butyl, and t-butyl groups.

The perfluoroalkyl group is not particularly limited, and examples thereof include any saturated perfluoroalkyl group, and any unsaturated perfluoroalkyl group. The perfluoroalkyl group may have a linear structure or a branched structure. More specific examples of the perfluoroalkyl group include trifluoromethyl, perfluoroethyl, perfluoro-n-propyl,

perfluoroisopropyl, perfluoro-n-butyl, perfluoro-sec-butyl, perfluoro-tert-butyl, perfluoro-n-amyl, perfluoro-sec-amyl, perfluoro-tert-amyl, perfluoroisoamyl, perfluoro-n-hexyl, perfluoroisohexyl, perfluoroneohexyl, perfluoro-n-heptyl, perfluoroisoheptyl, perfluoroneoheptyl, perfluoro-n-octyl, perfluoroisooctyl, perfluoroneooctyl, perfluoro-n-nonyl, perfluoroneononyl, perfluoroisononyl, perfluoro-n-decyl, perfluoroisodecyl, perfluoroneodecyl, perfluoro-sec-decyl, and perfluoro-tert-decyl groups.

[Compound (B)]

The compound (B) may be a fluorocycloalkane having 3 to 6 carbon atoms and represented by the general formula (2):

$$C_mH_nF_{2m-n} \qquad (2)$$

wherein m represents an integer of 3 to 6 both inclusive, n represents an integer of 0 or more, and "2m - n" ≥ 1.

More specific examples of the fluorocycloalkane having 3 to 6 carbon atoms include monofluorocyclohexane, dodecafluorocyclohexane, 1,1,4-trifluorocyclohexane, 1,1,2,2-tetrafluorocyclobutane, 1,1,2,2,3-pentafluorocyclobutane, 1,2,2,3,3,4-hexafluorocyclobutane, 1,1,2,2,3,3-hexafluorocyclobutane, 1,1,2,2,3,3-hexafluorocyclobutane, 1,1,2,2,3,4-hexafluorocyclobutane, 1,1,2,2,3,3-hexafluorocyclopentane, 1,1,2,2,3,4-hexafluorolcyclopentane, 1,1,2,2,3,3,4-heptafluorocyclopentane, 1,1,2,2,3,4,5-heptafluorocyclopentane, 1,1,2,2,3,3,4,4-octafluorocyclopentane, 1,1,2,2,3,3,4,5-octafluorocyclopentane, 1,1,2,2,3,3,4,5-octafluorocyclopentane, 1,1,2,2,3,4,5,6-octafluorocyclohexane, 1,1,2,2,3,3,4,4-octafluorocyclohexane, 1,1,2,2,3,3,4,4-octafluorocyclohexane, 1,1,2,2,3,3,4,5-octafluorocyclohexane, 1,1,2,2,3,4,4,5,6-nonafluorocyclohexane, 1,1,2,2,3,3,4,4,5-nonafluorocyclohexane, 1,1,2,2,3,3,4,5,6-nonafluorocyclohexane, 1,1,2,2,3,3,4,5,5,6-decafluorocyclohexane, 1,1,2,2,3,3,4,4,5,6-decafluorocyclohexane, 1,1,2,2,3,3,4,4,5,5-decafluorocyclohexane, 1,1,2,2,3,3,4,4,5,6-decafluorocyclohexane, perfluorocyclopropane, perfluorocyclobutane, perfluorocyclopentane, and perfluorocyclohexane.

The compound (B) may be the fluorocycloalkane, which has 3 to 6 carbon atoms, to which a substituent is bonded. The substituent may be at least one selected from the group consisting of halogen groups other than a fluoro group (specifically, chloro, bromo and iodo groups), a hydroxyl group, an oxygen atom, alkyl groups, a carboxyl group, and perfluoroalkyl groups. The alkyl group and the perfluoroalkyl group are not particularly limited. Examples thereof are the same as described about the compound (A).

Specific examples of the compound (B) in which a substituent is bonded to the fluorocycloalkane, which has 3 to 6 carbon atoms, include 1,2,2,3,3-tetrafluoro-1-trifluoromethylcyclobutane, 1,2,4,4-tetrafluoro-1-trifluoromethylcyclobutane, 2,2,3,3-tetrafluoro-1-trifluoromethylcyclobutane, 1,2,2-trifluoro-1-trimethylcyclobutane, 1,4,4,5,5-pentafluoro-1,2,2,3,3-pentamethylcyclopentane, 1,2,5,5-tetrafluoro-1,2-dimethylcyclopentane, 3,3,4,4,5,5,6,6-octafluoro-1,2-dimethylcyclohexane, 1,1,2,2-tetrachloro-3,3,4,4-tetrafluorocyclobutane, 2-fluorocyclohexanol, 4,4-difluorocyclohexanone, 4,4-difluorocyclohexanecarboxylic acid, 1,2,2,3,3,4,4,5,5,6,6-undecafluoro-1-(nonafluorobutyl)cyclohexanone, perfluoromethylcyclopropane, perfluorodimethylcyclopropane, perfluorotrimethylcyclopropane, perfluoromethylcyclobutane, perfluorodimethylcyclobutane, perfluorotrimethylcyclobutane, perfluoromethylcyclopentane, perfluorodimethylcyclopentane, perfluorotrimethyleyclopentane, perfluoromethylcyclohexane, perfluorodimethylcyclohexane, and perfluorotrimethylcyclohexane.

[Compound (C)]

Examples of the fluorobicycloalkane, which has 10 carbon atoms, as the compound (C) include fluorobicyclo[4.4.0]decane, fluorobicyclo[3.3.2]decane, perfluorobicyclo[4.4.0]decane, and perfluorobicyclo[3.3.2]decane.

The compound (C) may be the fluorobicycloalkane, which has 10 carbon atoms, to which a substituent is bonded. The substituent may be a halogen radical other than a fluoro group (specifically, a chloro, bromo or iodo groups), a cycloalkyl group which may have a halogen atom, or an alkyl group having a cycloalkyl group which may have a halogen atom.

In the cycloalkyl group which may have a halogen atom, examples of the halogen atom include fluorine, chlorine, bromine and iodine atoms. Examples of the cycloalkyl group which may have a halogen atom include cyclopropyl, cyclobutyl, cyclopentyl, cyclohexyl, cycloheptyl, perfluorocyclopropyl, perfluorocyclobutyl, perfluorocyclopentyl, perfluorocyclohexyl, and perfluorocycloheptyl groups.

In the alkyl group having a cycloalkyl group which may have a halogen atom, examples of the halogen atom include fluorine, chlorine, bromine and iodine atoms. In the alkyl group having a cycloalkyl group which may have a halogen atom, this cycloalkyl group, which may have a halogen atom, may be, for example, a cyclopropyl, cyclobutyl, cyclopentyl, cyclohexyl, cycloheptyl, perfluorocyclopropyl, perfluorocyclobutyl, perfluorocyclopentyl, perfluorocyclohexyl or perfluorcycloheptyl group. A specific example of the alkyl group having a cycloalkyl group which may have a halogen

atom is a difluoro(undecafluorocyclohexyl)methyl group.

A specific example of the compound (C) in which a substituent is bonded to the fluorobicycloalkane, which has 10 carbon atoms, is 2-[difluoro(undecafluorocyclohexyl)methyt]-1,1,2,3,3,4,4,4a,5,5,6,6,7,7,8,8,8a-heptadecafluorodecahydronaphthalene.

[Compound (D)]

An example of the fluorotetracyanoquinodimethane as the compound (D) is tetrafluorocyanoquinodimethane.

The compound (D) may be, for example, a compound in which at least one of halogen groups other than a fluoro group (specifically, chloro, bromo, and iodo groups) is bonded to the fluorotetracyanoquinodimethane.

[Compound (E)]

Examples of the fluorocyclotriphosphazene as the compound (E) include hexafluorocyclotriphosphazene, octafluorocyclotetraphosphazene, decafluorocyclopentaphosphazene, and dodecafluorocyclohexaphosphazene.

The compound (E) may be a compound in which a substituent is bonded to the fluorocyclotriphosphazene. Examples of the substituent include halogen groups other than a fluoro group (specifically, chloro, bromo and iodo groups), and phenoxy and alkoxy (-OR) groups. Examples of R in the alkoxy groups include alky, fluoroalkyl, and aromatic groups. Examples of R include methyl, ethyl and other alkyl groups; trifluoromethyl and other fluoroalkyl groups; and phenyl and other aromatic groups.

Specific examples of the compound (E) in which a substituent as described above is bonded to the fluorocyclotriphosphazene include hexachlorocyclotriphosphazene, octachlorocyclotetraphosphazene, decachlorocyclopentaphosphazene, dodecacyclohexaphosphazene, and hexaphenoxycyclotriphosphazene.

<1-3 Substrate treating method>

A substrate treating method using the substrate treating apparatus 1 of the present embodiment will then be described below with reference to Figs. 9 to 11. Fig. 9 is a flowchart showing the operation of the substrate treating apparatus 1 according to the first embodiment. Fig. 10 is a schematic view showing the state of the substrate W in individual steps of Fig. 9. Fig. 11A is a schematic view showing the states of a supplying step and a temperature adjusting step of the process liquid in the substrate treating method, Fig. 11B is a schematic view showing the state of a solidifying step of the process liquid and Fig. 11C is a schematic view showing a state where a solidified body is formed. On the substrate W, a concave/convex pattern Wp is formed in the preceding step. The pattern Wp includes convex portions Wp1 and concave portions Wp2. In the present embodiment, the height of the convex portion Wp1 falls within a range of 100 to 600 nm, and the width thereof falls within a range of 5 to 50 nm. The shortest distance between two adjacent convex portions Wp1 (the shortest width of the concave portions Wp2) falls within a range of 5 to 150 nm. The aspect ratio of the convex portion Wp1, that is, a value (height/width) obtained by dividing the height by the width falls within a range of 5 to 35.

The individual steps shown in (a) to (e) shown in Fig. 10 are processed under the atmospheric pressure environment unless otherwise explicitly indicated. Here, the atmospheric pressure environment refers to an environment which is equal to or more than 0.7 atmospheres and equal to or less than 1.3 atmospheres with the standard atmospheric pressure (1 atmosphere, 1013 hPa) in the center. In particular, when the substrate treating apparatus 1 is arranged within a clean room having a positive pressure, the environment of the front surface Wa of the substrate W is higher than 1 atmosphere.

An operator first provides an instruction to perform a substrate processing program 19 corresponding to a predetermined substrate W. Thereafter, as a preparation for loading the substrate W into the substrate treating apparatus 1, the operation instruction is provided by the control unit 13 so as to perform the following operation. Specifically, the rotation of the chuck rotation mechanism 56 is stopped, and the chuck pins 54 are located in positions suitable for receiving and delivering the substrate W. The valves 26, 36, 46 and 74 are closed, and the nozzles 22, 32 and 42 are respectively located in the retraction positions P1, P2 and P3. Then, the chuck pins 54 are brought into an opened state by an unillustrated opening/closing mechanism.

When the unprocessed substrate W is loaded into the substrate treating apparatus 1 by an unillustrated substrate loading/unloading mechanism and is placed on the chuck pins 54, the chuck pins 54 are brought into a closed state by the unillustrated opening/closing mechanism.

After the unprocessed substrate W is held by the substrate holder 51, a washing step S11 is performed on the substrate by an unillustrated wet washing unit. The washing step S11 includes rinse processing for supplying a washing liquid to the front surface Wa of the substrate W so as to perform washing and then removing the washing liquid. The washing liquid is not particularly limited, and for example, SC-1 (liquid containing ammonia, a hydrogen peroxide solution

and water), SC-2 (liquid containing hydrochloric acid, a hydrogen peroxide solution and water) and the like can be mentioned. The rinse liquid is not particularly limited, and for example, DIW and the like can be mentioned. The amounts of washing liquid and rinse liquid supplied are not particularly limited, and can be set as necessary according to the range which is washed and the like. The washing time is not particularly limited, and can be set as necessary.

In the present embodiment, the wet washing unit is used, thus the SC-1 is supplied to the front surface Wa of the substrate W so as to wash the front surface Wa and thereafter the DIW is further supplied to the front surface Wa so as to remove the SC-1.

(a) shown in Fig. 10 shows a state of the substrate W when the washing step S11 is completed. As shown in the figure, on the front surface Wa of the substrate W on which the pattern Wp is formed, the DIW (represented by "60" in the figure) supplied in the washing step S11 is adhered.

An IPA rinsing step S12 of supplying the IPA to the front surface Wa of the substrate W on which the DIW 60 is adhered is performed (see Fig. 9). The control unit 13 first provides the operation instruction to the chuck rotation mechanism 56 such that the substrate W is rotated about the axis A1 at a constant speed.

Then, the control unit 13 provides the operation instruction to the revolvingly driving part 14 such that the nozzle 32 is located in the center portion of the front surface Wa of the substrate W. Then, the control unit 13 provides the operation instruction to the valve 36 such that the valve 36 is opened. In this way, the IPA is supplied from the IPA tank 37 through the pipe 35 and the nozzle 32 to the front surface Wa of the substrate W.

The IPA supplied to the front surface Wa of the substrate W is made to flow from around the center of the front surface Wa of the substrate W toward the peripheral portion of the substrate W by centrifugal force generated by the rotation of the substrate W so as to be diffused over the entire front surface Wa of the substrate W. In this way, the DIW adhered to the front surface Wa of the substrate W is removed by the supply of the IPA, and thus the entire front surface Wa of the substrate W is covered with the IPA. The rotation speed of the substrate W is preferably set such that the thickness of the film formed of the IPA is higher than the height of the convex portions Wp1 on the entire front surface Wa. The amount of IPA supplied is not particularly limited, and can be set as necessary.

After the completion of the IPA rinsing step S12, the control unit 13 provides the operation instruction to the valve 36 such that the valve 36 is closed. The control unit 13 also provides the operation instruction to the revolvingly driving part 14 such that the nozzle 32 is located in the retraction position P2.

(b) shown in Fig. 10 shows a state of the substrate W when the IPA rinsing step S12 is completed. As shown in the figure, on the front surface Wa of the substrate W on which the pattern Wp is formed, the IPA (represented by "61" in the figure) supplied in the IPA rinsing step S12 is adhered, and the DIW 60 is replaced by the IPA 61 so as to be removed from the front surface Wa of the substrate W.

A process liquid supplying step (supplying step) S13 of supplying the process liquid which contains the sublimable substance in a molten state and which serves as the dry assistant liquid to the front surface Wa of the substrate W on which the IPA 61 is adhered and a temperature adjusting step S14 are then performed (see Fig. 9). Specifically, the control unit 13provides the operation instruction to the chuck rotation mechanism 56 such that the substrate W is rotated about the axis A1 at a constant speed. Here, the rotation speed of the substrate W is preferably set such that the thickness of the liquid film formed of the process liquid is higher than the height of the convex portions Wp1 on the entire front surface Wa.

Then, the control unit 13 provides the operation instruction to the revolvingly driving part 14 such that the nozzle 22 is located in the center portion of the front surface Wa of the substrate W. The control unit 13 then provides the operation instruction to the valve 26 such that the valve 26 is opened. In this way, the process liquid is supplied from the process liquid storing tank 271 through the pipe 25 and the nozzle 22 to the front surface Wa of the substrate W. The process liquid supplied to the front surface Wa of the substrate W is made to flow from around the center of the front surface Wa of the substrate W toward the peripheral portion of the substrate W by centrifugal force generated by the rotation of the substrate W so as to be diffused over the entire front surface Wa of the substrate W. In this way, the IPA adhered to the front surface Wa of the substrate W is removed by the supply of the process liquid such that the entire front surface Wa of the substrate W is covered with the process liquid.

The temperature of the supplied process liquid is set within a range equal to or above the melting point of the sublimable substance and below the boiling point thereof at least after the process liquid is supplied to the front surface Wa of the substrate W. For example, when as the sublimable substance, 1, 1, 2, 2, 3, 3, 4-heptafluorocyclopentane (having a boiling point of 82.5°C) described above is used, the temperature is preferably set within a range equal to or more than 35°C and equal to or less than 82°C. In this way, it is possible to form, on the front surface Wa of the substrate W, the liquid film made of the process liquid 62. The amount of process liquid supplied is not particularly limited, and can be set as necessary.

For example, when the temperature of the substrate W and the temperature of an atmosphere within the chamber 11 are equal to or below the melting point of the sublimable substance, the temperature of the process liquid

62 immediately before being supplied in the process liquid supplying step S13 is adjusted at a temperature sufficiently higher than the melting point in order to prevent the process liquid 62 from being solidified on the substrate W after the supply. However, in the present embodiment, since not only the process liquid supplying step S13 but also the temperature adjusting step S14 is performed, even when the process liquid 62 at a temperature slightly higher than the melting point of the sublimable substance is supplied, the process liquid 62 after being supplied can be prevented from being solidified on the front surface Wa of the substrate W.

On the other hand, the control unit 13 also provides the operation instruction to the valve 84 such that the valve 84 is opened. In this way, as shown in Fig. 11A, the heat medium 64 in a fluid state stored in the heat medium tank 821 is discharged through the pipe 83 and the supply pipe 852 from the discharge portion 853 toward the back surface Wb of the substrate W. Furthermore, with the heat medium 64 discharged from the discharge portion 853, the area between the back surface Wb of the substrate W and the opposite member 851 is filled (see Fig. 11A). The supply of the heat medium 64 can be performed either continuously or intermittently. With consideration given to the thickness of the substrate W and the like, the temperature of the heat medium 64 is preferably set such that the process liquid 62 forming the liquid film on the front surface Wa of the substrate W can be controlled within a temperature range equal to or above the melting point of the sublimable substance and below the boiling point thereof. In this way, it is possible to prevent the process liquid 62 from being solidified due to sublimation heat generated by the vaporization of the sublimable substance. The amount of heat medium 64 supplied is also not particularly limited as long as the heat medium 64 can make contact with the back surface Wb of the substrate W.

As described above, the temperature of the process liquid 62 supplied to the front surface Wa of the substrate W is controlled with the heat medium 64 so as to be equal to or above the melting point of the sublimable substance, and thus it is possible to prevent the process liquid 62 from being solidified due to the sublimation heat of the sublimable substance. Consequently, it is possible to prevent the formation of a solidified body having an internal stress and the like, and thus it is possible to reduce the collapse of the pattern Wp caused by the internal stress of the solidified body. It is also possible to prevent the formation of a solidified body having a large film thickness, and the collapse of the pattern Wp caused thereby can also be prevented. Furthermore, it is also possible to reduce a residue such as particles generated on the front surface Wa of the substrate W after a sublimating step which will be described later. The "internal stress" described above means a stress which is produced by relation to a crystal growth mechanism in the solidified body and a film formation process, and can include not only a stress produced within the crystal (solidified body) but also a tension produced on the surface of the crystal (solidified body).

When the process liquid supplying step S13 is completed, the control unit 13 provides the operation instruction to the valve 26 such that the valve 26 is closed. The control unit 13 also provides the operation instruction to the revolvingly driving part 14 such that the nozzle 22 is located in the retraction position P1. Furthermore, when the temperature adjusting step S14 is completed, the control unit 13 also provides the operation instruction to the valve 84 such that the valve 84 is closed.

The temperature adjusting step S14 can be started by opening the valve 84 simultaneously with the start of the process liquid supplying step S13. Here, the start of the process liquid supplying step S13 means the time when the valve 26 is opened in the process liquid supplying unit 21. The temperature adjusting step S14 may be started during the process liquid supplying step S13, for example, after an arbitrary time has elapsed since the start of the supply of the process liquid 62. In this case, even when the solidification of part of the liquid film of the process liquid 62 has been started, since it is heated beyond the melting point of the sublimable substance, it is possible to return it again to the molten state of the liquid film.

As long as the temperature adjusting step S14 is completed before the start of the solidifying step S15, the time of the completion thereof is not particularly limited, and the temperature adjusting step S14 is preferably completed by closing the valve 84 simultaneously with the completion of the process liquid supplying step S13. In this way, at least during the process liquid supplying step S13, the process liquid 62 can be prevented from being solidified. Here, the completion of the process liquid supplying step S13 means the time when the valve 26 is closed in the process liquid supplying unit 21.

Furthermore when a spin-off step for spinning off the process liquid 62 is provided between the process liquid supplying step S13 and the solidifying step S15, the temperature adjusting step S14 may be completed during the spin-off step or simultaneously with the completion of the spin-off step. The spin-off step for the process liquid 62 is performed in order to spin off an excess of the process liquid 62 supplied to the front surface Wa of the substrate W from the front surface Wa of the substrate W by utilization of action of centrifugal force generated by the rotation of the substrate W.

(c) shown in Fig. 10 shows a state of the substrate W when the process liquid supplying step S13 and the temperature adjusting step S14 are completed. As shown in the figure, on the front surface Wa of the substrate W on which the pattern Wp is formed, the process liquid 62 supplied in the process liquid supplying step S13 is adhered so as to form a liquid film, and the IPA 61 is replaced by the process liquid 62 so as to be removed from the front surface Wa of the substrate W. The heat medium 64 makes contact with the back surface Wb of the substrate W, and thus

the liquid film of the process liquid 62 on the front surface Wa is prevented from being solidified.

As shown in Fig. 9, the solidifying step S15 of solidifying the process liquid 62 supplied to the front surface Wa of the substrate W so as to form a solidified film of the sublimable substance is then performed. The control unit 13 first provides the operation instruction to the chuck rotation mechanism 56 such that the substrate W is rotated about the axis A1 at a constant speed. Here, the rotation speed of the substrate W is set such that the process liquid 62 can form a predetermined film thickness higher than the convex portions Wp1 on the entire front surface Wa.

Then, the control unit 13 provides the operation instruction to the valve 94 such that the valve 94 is opened. In this way, the coolant (for example, cold water having a temperature of 7°C or the like) 65 stored in the coolant tank 921 is discharged through the pipe 93 and the supply pipe 852 from the discharge portion 853 toward the back surface Wb of the substrate W (see Fig. 11B).

The coolant 65 supplied toward the back surface Wb of the substrate W is made to flow from around the center of the back surface Wb of the substrate W toward the direction of the peripheral portion of the substrate W by centrifugal force generated by the rotation of the substrate W so as to be diffused over the entire back surface Wb of the substrate W. In this way, the liquid film of the process liquid 62 formed on the front surface Wa of the substrate W is cooled to a low temperature equal to or below the freezing point of the sublimable substance so as to be solidified, with the result that the solidified body 63 is formed (see Fig. 11C).

(d) shown in Fig. 10 shows a state of the substrate W when the solidifying step S15 is completed. As shown in the figure, the process liquid 62 supplied in the process liquid supplying step S13 is cooled by the supply of the coolant 65 to the back surface Wb of the substrate W so as to be solidified, with the result that the solidified body 63 containing the sublimable substance is formed.

Then, as shown in Fig. 9, a sublimating step S16 of subliming the solidified body 63 formed on the front surface Wa of the substrate W so as to remove it from the front surface Wa of the substrate W is performed. The sublimating step S16 is performed while the supply of the cold water to the back surface Wb of the substrate W by the coolant supplying unit 91 is being continued. In this way, the solidified body 63 can be cooled at a temperature equal to or below the freezing point of the sublimable substance, and thus it is possible to prevent, from the side of the back surface Wb of the substrate W, the sublimable substance from being melted.

In the sublimating step S16, the control unit 13 first provides the operation instruction to the chuck rotation mechanism 56 such that the substrate W is rotated about the axis A1 at a constant speed. Here, the rotation speed of the substrate W is set such that the process liquid 62 can form a predetermined film thickness higher than the convex portions Wp1 on the entire front surface Wa.

Then, the control unit 13 provides the operation instruction to the revolvingly driving part 14 such that the nozzle 42 is located in the center portion of the front surface Wa of the substrate W. Then, the control unit 13 provides the operation instruction to the valve 46 such that the valve 46 is opened. In this way, the gas (in the present embodiment, nitrogen gas having a temperature of 7°C) is supplied from the gas tank 471 through the pipe 45 and the nozzle 42 toward the front surface Wa of the substrate W.

Here, the partial pressure of the vapor of the sublimable substance in the nitrogen gas is set lower than the saturated vapor pressure of the sublimable substance at a temperature when the nitrogen gas is supplied. Hence, the nitrogen gas described above is supplied to the front surface Wa of the substrate W so as to make contact with the solidified body 63, and thus the sublimable substance is sublimed from the solidified body 63 into the nitrogen gas. Since the nitrogen gas has a temperature lower than the melting point of the sublimable substance, it is possible to sublime the solidified body 63 while preventing the melting of the solidified body 63.

In this way, the sublimable substance in a solid state is sublimed, and thus when the substances such as the IPA present on the front surface Wa of the substrate W are removed, it is possible to satisfactorily dry the front surface Wa of the substrate W while the surface tension is prevented from acting on the pattern Wp so as to reduce the occurrence of a pattern collapse.

(e) shown in Fig. 10 shows a state of the substrate W when the sublimating step S16 is completed. As shown in the figure, the solidified body 63 of the dry auxiliary substance formed in the solidifying step S15 is sublimed by the supply of the nitrogen gas having a temperature of 7°C so as to be removed from the front surface Wa, with the result that the drying of the front surface Wa of the substrate W is completed.

After the completion of the sublimating step S16, the control unit 13 provides the operation instruction to the valve 46 such that the valve 46 is closed. The control unit 13 also provides the operation instruction to the revolvingly driving part 14 such that the nozzle 42 is located in the retraction position P3.

In this way, a series of substrate dry processing steps are completed. After the substrate dry processing as described above, the substrate W on which the dry processing has been performed is unloaded from the chamber 11 by the unillustrated substrate loading/unloading mechanism.

As described above, in the present embodiment, when the process liquid is supplied to the front surface Wa of the substrate W, the temperature of the process liquid supplied on the front surface Wa of the substrate W is controlled

so as to fall within a range equal to or above the melting point of the sublimable substance and below the boiling point thereof. In this way, in a process in which the process liquid is supplied to the substrate W, the formation of a solidified body having an internal stress is prevented, and thus it is possible to reduce the collapse of the pattern caused by the formation of the solidified body. Furthermore, it is possible to reduce the leaving of the particles contained in the process liquid on the substrate W as the residue.

(Second embodiment)

A second embodiment according to the present invention will be described below.

The present embodiment differs from the first embodiment in that even in the IPA rinsing step S12, the temperature adjusting step S14 is performed. Even in the configuration described above, in the present embodiment, it is possible to satisfactorily dry the surface of the substrate W while more reducing the collapse of the pattern.

<2-1 Configuration of substrate treating apparatus and process liquid>

A substrate treating apparatus and a control unit according to the second embodiment basically have the same configurations as the substrate treating apparatus 1 and the control unit 13 according to the first embodiment (see Figs. 1 and 2), and thus they are identified with the same symbols, and the description thereof will be omitted. The process liquid (dry assistant liquid) used in the present embodiment is also the same as that according to the first embodiment, and thus the description thereof will be omitted.

<2-2 Substrate treating method>

Next, a substrate treating method according to the second embodiment using the substrate treating apparatus 1 having the same configuration as in the first embodiment will be described.

The steps of the substrate treating will be described below with reference to Figs. 1 to 3, Figs. 12 and 13 as necessary. Fig. 12 is a flowchart showing the operation of the substrate treating apparatus 1 according to the second embodiment. Fig. 13 is a schematic view showing the state of the substrate W in the individual steps of Fig. 12. In the second embodiment, the washing step S11, the process liquid supplying step S13, the solidifying step S15 and the sublimating step S15 shown in Fig. 12 and (a) and (c) to (e) shown in Fig. 13 are the same as in the first embodiment, and thus the description thereof will be omitted.

The individual steps shown in (a) to (d) shown in Fig. 13 are processed under the atmospheric pressure environment unless otherwise indicated. The processing (details of which will be described later) shown in (e) shown in Fig. 13 is performed under a reduced pressure environment of 17 Pa ($17 \times 10^{-5}$ atmospheres).

As shown in Fig. 12, after the washing step S11 is performed, the IPA rinsing step S12 of supplying the IPA 61 to the front surface Wa of the substrate W to which the DIW 60 is adhered and the temperature adjusting step S14 are performed. In other words, the control unit 13 provides the operation instruction to the chuck rotation mechanism 56 such that the substrate W is rotated around the axis A1 at a constant speed.

Then, the control unit 13 provides the operation instruction to the revolvingly driving part 14 such that the nozzle 32 is located in the center portion of the front surface Wa of the substrate W. The control unit 13 then provides the operation instruction to the valve 36 such that the valve 36 is opened. In this way, the IPA 61 is supplied from the IPA tank 37 through the pipe 35 and the nozzle 32 to the front surface Wa of the substrate W. The IPA 61 supplied to the front surface Wa of the substrate W is made to flow from around the center of the front surface Wa of the substrate W toward the peripheral portion of the substrate W by centrifugal force generated by the rotation of the substrate W so as to be diffused over the entire front surface Wa of the substrate W. In this way, the DIW 60 adhered to the front surface Wa of the substrate W is removed by the supply of the IPA 61 such that the entire front surface Wa of the substrate W is covered with the IPA 61.

On the other hand, the control unit 13 also provides the operation instruction to the valve 84 such that the valve 84 is opened. In this way, the heat medium 64 in a fluid state stored in the heat medium tank 821 is discharged through the pipe 83 and the supply pipe 852 from the discharge portion 853 toward the back surface Wb of the substrate W. Furthermore, with the heat medium 64 discharged from the discharge portion 853, the area between the back surface Wb of the substrate W and the opposite member 851 is filled. With consideration given to the thickness of the substrate W and the like, the temperature of the heat medium 64 is preferably set such that the process liquid supplied to the front surface Wa of the substrate W is controlled within a temperature range equal to or above the melting point of the sublimable substance and below the boiling point thereof. In this way, it is possible to prevent the substrate W from being cooled to, for example, room temperature or below due to sublimation heat generated by the vaporization of the IPA 61 forming the liquid film. Consequently, it is possible to prevent the process liquid 62 from being cooled so as to be solidified when in the process liquid supplying step S13, the process liquid 62 is supplied to the front surface Wa of

the substrate W.

After the completion of the IPA rinsing step S12, the control unit 13 provides the operation instruction to the valve 36 such that the valve 36 is closed. The control unit 13 also provides the operation instruction to the revolvingly driving part 14 such that the nozzle 32 is located in the retraction position P2.

(b) shown in Fig. 13 shows a state of the substrate W when the IPA rinsing step S12 is completed. As shown in the figure, on the front surface Wa of the substrate W on which the pattern Wp is formed, the IPA 61 supplied in the IPA rinsing step S12 is adhered, and the DIW 60 is replaced by the IPA 61 so as to be removed from the front surface Wa of the substrate W. The heat medium 64 makes contact with the back surface Wb of the substrate W, and thus the substrate W is prevented from being cooled to, for example, room temperature or below.

The temperature adjusting step S14 can be started by opening the valve 84 simultaneously with the start of the IPA rinsing step S12. The temperature adjusting step S14 is performed in order to prevent the substrate W from being cooled, and thus at least until the process liquid supplying step S13 is started, the substrate W preferably has a temperature equal to or above the melting point of the sublimable substance. Hence, the temperature adjusting step S14 may be started during the IPA rinsing step S12, for example, after an arbitrary time has elapsed since the start of the supply of the IPA 61.

In the temperature adjusting step S14, the supply of the heat medium 64 is continuously performed even in the process liquid supplying step (supplying step) S13 of supplying the process liquid that contains the sublimable substance in a molten state and that serves as the dry assistant liquid to the front surface Wa of the substrate W to which the IPA 61 is adhered (see Fig. 12).

As described above, in the present embodiment, the temperature adjusting step S14 is performed both in the IPA rinsing step S12 and in the process liquid supplying step S13. Hence, in the present embodiment, as in the first embodiment, in the process liquid supplying step S13, it is possible to prevent the process liquid from being solidified due to sublimation heat generated by the vaporization of the process liquid. In the IPA rinsing step S12, it is also possible to prevent the solidification of the process liquid supplied in the process liquid supplying step S13 as a result of the substrate W being cooled due to the sublimation heat generated by the vaporization of the IPA 61.

(Variations)

In the above discussion, the preferred embodiments of the present invention are described. However, the present invention is not limited to these embodiments, and can be practiced in other various forms. The major ones of the other various forms will be illustrated below.

In the first embodiment and the second embodiment, within the one chamber 11, the individual steps are performed on the substrate W. However, there is no limitation to this configuration in the practice of the present invention, and a chamber may be prepared for each of the steps.

For example, in each of the embodiments, the following configuration may be adopted in which the steps up to the solidifying step S15 are performed in a first chamber, in which after the solidified film is formed on the front surface Wa of the substrate W, the substrate W is unloaded from the first chamber, in which the substrate W where the solidified film is formed is loaded into a separate second chamber and in which the sublimating step S16 is performed in the second chamber.

In the first embodiment and the second embodiment, in the solidifying step S15, the coolant 65 is supplied by the coolant supplying unit 91 toward the back surface Wb of the substrate W so as to solidify the process liquid. However, the present invention is not limited to these embodiments. For example, instead of the supply of the coolant 65 by the coolant supplying unit 91, nitrogen gas may be supplied by the gas supplying unit 41 to the liquid film of the process liquid 62 so as to perform the solidifying step. Alternatively, while the coolant 65 is being supplied by the coolant supplying unit 91 toward the back surface Wb of the substrate W, nitrogen gas may be supplied by the gas supplying unit 41 to the liquid film of the process liquid 62 so as to perform the solidifying step.

In the first embodiment and the second embodiment, in the sublimating step S16, the nitrogen gas is supplied by the gas supplying unit 41 while the supply of the coolant 65 by the coolant supplying unit 91 is being continued. However, the present invention is not limited to these embodiments, and for example, the supply of the nitrogen gas by the gas supplying unit 41 may be stopped such that the sublimable substance in the solidified body 63 is naturally sublimed while the coolant 65 is being supplied by the coolant supplying unit 91.

Furthermore, in the first embodiment and the second embodiment, in the solidifying step S15 and the sublimating step S16, instead of the coolant supplying unit 91, the pressure reducing unit 71 may be used. Specifically, in the solidifying step S15, the control unit 13 provides the operation instruction to the exhaust pump 72 such that the drive of the exhaust pump 72 is started. Then, the control unit 13 provides the operation instruction to the valve 74 such that the valve 74 is opened. In this way, the gas within the chamber 11 is exhausted through the pipe 73 to the outside of the

chamber 11. The interior of the chamber 11 is brought into a sealed state except the pipe 73, and thus the internal environment of the chamber 11 is reduced in pressure from atmospheric pressure.

The pressure reduction is performed from atmospheric pressure (about 1 atmosphere, about 1013 hPa) to about $1.7 \times 10^{-5}$ atmospheres (1.7 Pa). There is no limitation to the gas pressure described above in the practice of the invention of the present application, and the gas pressure within the chamber 11 after the pressure reduction may be set as necessary according to the pressure resistance and the like of the chamber 11 and the like. The interior of the chamber 11 is reduced in pressure, and thus the sublimable substance is vaporized from the process liquid 62 supplied to the front surface Wa of the substrate W. Here, sublimation heat is deprived from the process liquid 62, and thus the process liquid 62 is cooled so as to be solidified.

In the sublimating step S16, by the pressure reduction processing, the pressure of the environment within the chamber 11 is lower than the saturated vapor pressure of the dry auxiliary substance. Consequently, the pressure reduction environment as described above is maintained, and thus the sublimable substance is sublimed from the solidified body 63.

Preferred examples of this invention will be illustratively described in detail below. However, unless otherwise restrictively described, materials, mixed amounts and the like described in the examples are not intended to limit the scope of this invention.

(Substrate)

As a substrate, a silicon substrate in which a model pattern was formed on its front surface was prepared. Fig. 14 shows an SEM (Scanning Electron Microscope) image showing the surface of the silicon substrate on which the model pattern is formed. As the model pattern, a pattern was adopted in which cylinders (whose aspect ratio is 17) having a diameter of 30 nm and a height of 500 nm were aligned at intervals of about 60 nm. In Fig. 14, portions shown in white are the head portions of the cylinder portions (that is, the convex portions of the pattern), and portions shown in black are the concave portions of the pattern. As shown in Fig. 14, it was confirmed that on the pattern-formed surface, white circles which were substantially equal in size to each other were aligned regularly.

(Example 1)

In the present example, by procedures described below, dry processing was performed on the silicon substrate, and the effect of reducing the collapse of the pattern was evaluated. In the processing of the silicon substrate, the substrate treating apparatus described in the first embodiment was used.

<Procedure 1-1 Radiation of ultraviolet rays>

Initially, ultraviolet rays were radiated onto the front surface of the silicon substrate to make the front surface property thereof hydrophilic. In this way, liquid easily entered the concave portions of the pattern, and thus after the supply of the liquid, an environment in which a pattern collapse easily occurred was artificially formed.

<Procedure 1-2 Supplying step and temperature adjusting step>

Then, within the chamber 11 under atmospheric pressure, a process liquid (dry assistant liquid (whose liquid temperature was 25°C)) formed by melting a sublimable substance was directly supplied to the dried pattern-formed surface of the silicon substrate. In this way, on the pattern-formed surface of the silicon substrate, a liquid film made of the process liquid was formed.

When the process liquid was supplied, DIW (deionized water) having a temperature of 25°C was supplied to the back surface of the silicon substrate simultaneously with the supply of the process liquid. In this way, the process liquid was prevented from being solidified on the pattern-formed surface. The supply of the DIW was completed simultaneously with the completion of the supply of the process liquid.

As the sublimable substance, 1, 1, 2, 2, 3, 3, 4-heptafluorocyclopentane represented by a chemical structural formula below was used. In the compound described above, its surface tension was 19.6 mN/m under an environment of 25°C, and its vapor pressure was 8.2 kPa (62.0 mmHg) under an environment of 20°C. The compound was a substance whose melting point and freezing point were 20.5°C and whose specific gravity was 1.58 under an environment of 25°C. Furthermore, the compound is excellent in the solubility of, for example, fluoropolymers so as to be used as a solvent for various types of coating agents and as a detergent for the stain of an oil film.

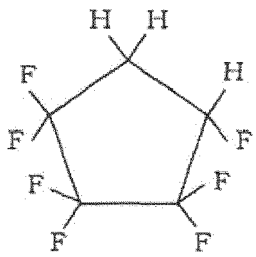

<Procedure 1-3 Solidifying step>

Then, under an atmospheric pressure environment, cold water having a temperature of 7°C was supplied to the back surface of the silicon substrate on which the liquid film made of the process liquid was formed, and thus the process liquid was solidified through the silicon substrate so as to form a solidified body. The thickness of the film of the solidified body which was formed was about 10 μm or less.

<Procedure 1-4 Sublimating step>

Furthermore, while the cold water of 7°C was being supplied continuously from the solidifying step, at normal temperature under atmospheric pressure environment, the nitrogen gas of 7°C was supplied to the solidified body. In this way, the sublimable substance (dry auxiliary substance) was sublimed while the melting of the solidified body was prevented, with the result that the solidified body was removed from the pattern-formed surface of the silicon substrate.

Fig. 15 is an SEM image of the silicon substrate after the procedures from 1-1 to 1-4 described above were performed. As compared with the pattern-formed surface (see Fig. 14) of the silicon substrate before the dry processing, the collapse of the pattern was hardly found, and the collapse rate in the displayed region was 1.28%. In this way, it is confirmed that when the process liquid is supplied to the pattern-formed surface of the substrate, the DIW having a temperature equal to or above the melting point of the sublimable substance and below the boiling point thereof is supplied from the side of the back surface of the substrate and thus the process liquid is prevented from being solidified through the substrate, with the result that it is possible to extremely satisfactorily reduce the collapse of the pattern.

The collapse rate described above was a value which was calculated by the formula below.

$$\text{collapse rate (\%)} = \text{(the number of convex portions collapsed in an arbitrary region)} / \text{(the total number of convex portions in the region)} \times 100$$

When the number of particles on the pattern-formed surface of the silicon substrate after the sublimating step was counted, it was about 1000 pieces, and thus it was possible to reduce the amount of particles in the residue.

The present invention can be applied to dry technology for removing liquid adhered to the front surface of a substrate and substrate processing technology in general for processing the front surface of a substrate using the dry technology.

## Claims

**1.** A substrate treating method of performing dry processing on a pattern-formed surface of a substrate, **characterized in that** the substrate treating method comprises:

a supplying step of supplying a process liquid containing a sublimable substance to the pattern-formed surface of the substrate;
a temperature adjusting step of adjusting a temperature of the substrate so as to control the process liquid supplied to the pattern-formed surface of the substrate within a temperature range equal to or above a melting point of the sublimable substance and below a boiling point thereof;
a solidifying step of solidifying, on the pattern-formed surface, the process liquid whose temperature is adjusted so as to form a solidified body; and
a sublimating step of subliming the solidified body so as to remove the solidified body from the pattern-formed surface,

wherein the temperature adjusting step is performed so as to overlap at least the supplying step and is completed at least before the solidifying step is started.

**2.** The substrate treating method according to claim 1,
**characterized in that** in the sublimable substance, a vapor pressure in a liquid state at room temperature is equal to or more than 300 Pa.

**3.** The substrate treating method according to claims 1 or 2,
**characterized in that** in the temperature adjusting step, a heat medium which is inert to at least the sublimable substance is brought into contact with a back surface on a side opposite to the pattern-formed surface of the substrate so as to control, through the substrate, a temperature of the process liquid supplied to the pattern-formed surface.

**4.** The substrate treating method according to any one of claims 1 to 3,
**characterized in that** in at least any one of the solidifying step and the sublimating step, an inert gas which has a temperature equal to or below a freezing point of the sublimable substance and which is inert to at least the sublimable substance is supplied to the pattern-formed surface of the substrate.

**5.** The substrate treating method according to any one of claims 1 to 4,
**characterized in that** in at least any one of the solidifying step and the sublimating step, a coolant at a temperature equal to or below a freezing point of the sublimable substance is supplied toward a back surface on a side opposite to the pattern-formed surface of the substrate.

**6.** The substrate treating method according to any one of claims 1 to 5,
**characterized in that** in the sublimating step, the pattern-formed surface on which the solidified body is formed in the solidifying step is reduced in pressure to an environment lower than atmospheric pressure.

**7.** The substrate treating method according to any one of claims 1 to 6,
**characterized in that** the temperature adjusting step is started before start of the supplying step, at the start of the supplying step or during the supplying step, and is completed during the supplying step, at completion of the supplying step and after the completion of the supplying step.

**8.** The substrate treating method according to any one of claims 1 to 7,
**characterized in that** the sublimable substance contains a fluorocarbon compound.

**9.** A substrate treating apparatus which is used in a substrate treating method, **characterized in that** the substrate treating method includes:

a supplying step of supplying a process liquid containing a sublimable substance to a pattern-formed surface of a substrate;
a temperature adjusting step of adjusting a temperature of the substrate so as to control the process liquid supplied to the pattern-formed surface of the substrate within a temperature range equal to or above a melting point of the sublimable substance and below a boiling point thereof;
a solidifying step of solidifying, on the pattern-formed surface, the process liquid whose temperature is adjusted so as to form a solidified body; and
a sublimating step of subliming the solidified body so as to remove the solidified body from the pattern-formed surface,

the temperature adjusting step is performed so as to overlap at least the supplying step and is completed at least before the solidifying step is started,
the substrate treating apparatus includes:

a supplying unit adapted for supplying the process liquid containing the sublimable substance to the pattern-formed surface of the substrate;
a temperature adjusting unit adapted for adjusting the temperature of the substrate so as to control the process liquid supplied to the pattern-formed surface of the substrate within the temperature range equal to or above the melting point of the sublimable substance and equal to or below the boiling point thereof;
a solidifying unit adapted for solidifying, on the pattern-formed surface, the process liquid whose temperature is adjusted so as to form the solidified body; and

a sublimating unit adapted for subliming the solidified body so as to remove the solidified body from the pattern-formed surface and

the temperature adjusting unit supplies, to a back surface on a side opposite to the pattern-formed surface of the substrate, a heat medium which has a temperature equal to or above a melting point of the sublimable substance and below a boiling point thereof and which is inert to at least the sublimable substance.

F I G. 1

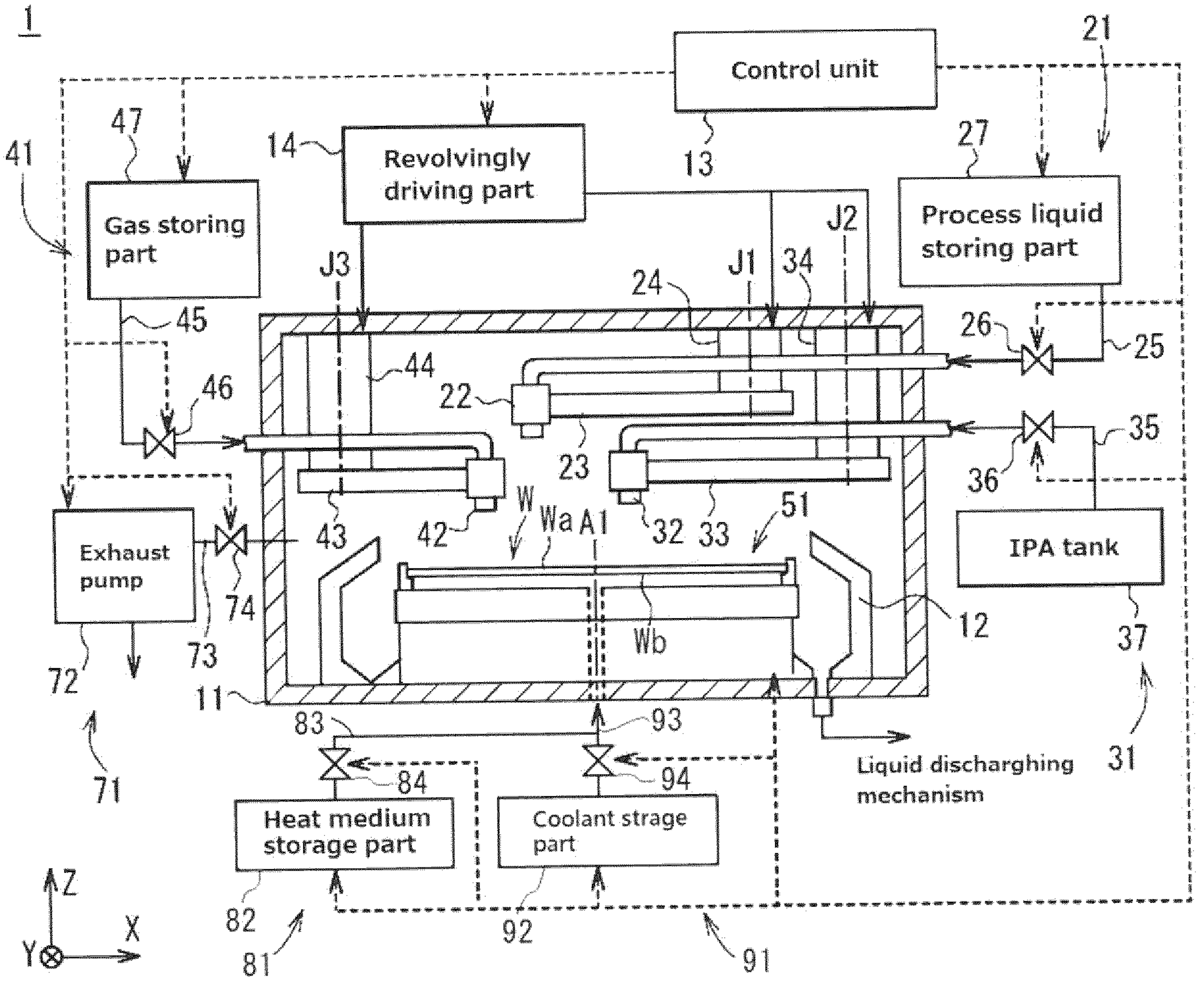
1
Control unit
21
47
41
14
Revolvingly driving part
13
27
Gas storing part
Process liquid storing part
J2
J3
J1
34
24
45
26
25
44
46
22
35
23
36
W
Wa
A1
32
33
51
42
43
Exhaust pump
74
IPA tank
12
Wb
73
37
72
11
83
93
84
94
Liquid discharghing mechanism
31
71
Heat medium storage part
Coolant strage part
Z
82
X
Y
92
81
91

F I G. 2

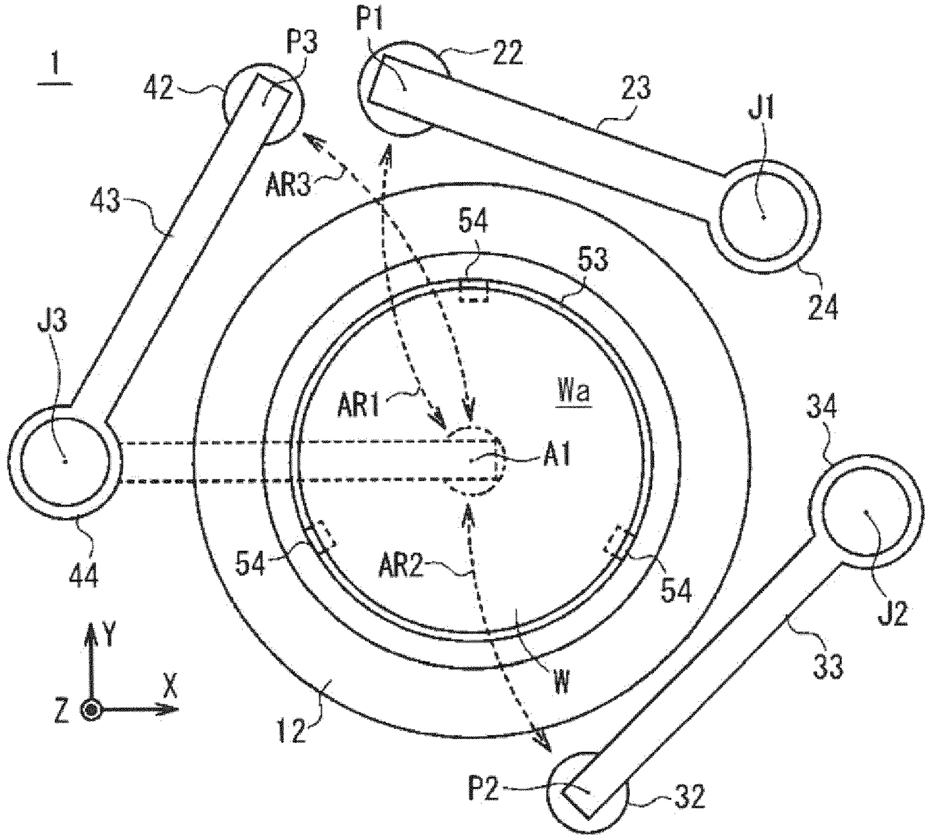
1
P3
42
P1
22
23
J1
AR3
43
54
53
24
J3
Wa
AR1
A1
44
54
AR2
54
34
J2
33
Y
X
Z
W
12
P2
32

F I G. 3

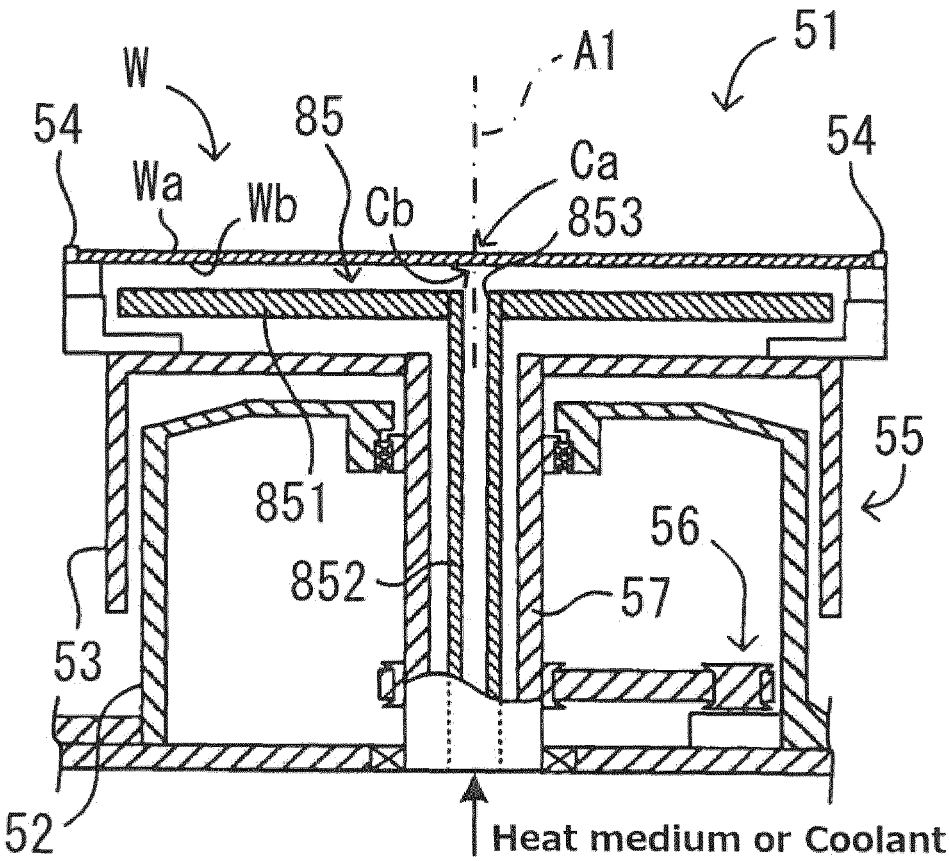

W
54
85
A1
51
54
Wa
Wb
Cb
Ca
853
851
55
56
852
57
53
52
Heat medium or Coolant

FIG. 4A

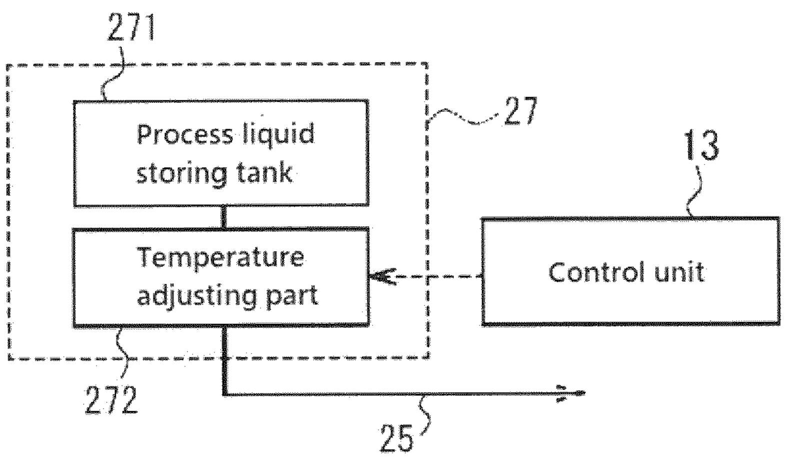
271
27
13
Process liquid storing tank
Temperature adjusting part
Control unit
272
25

FIG. 4B

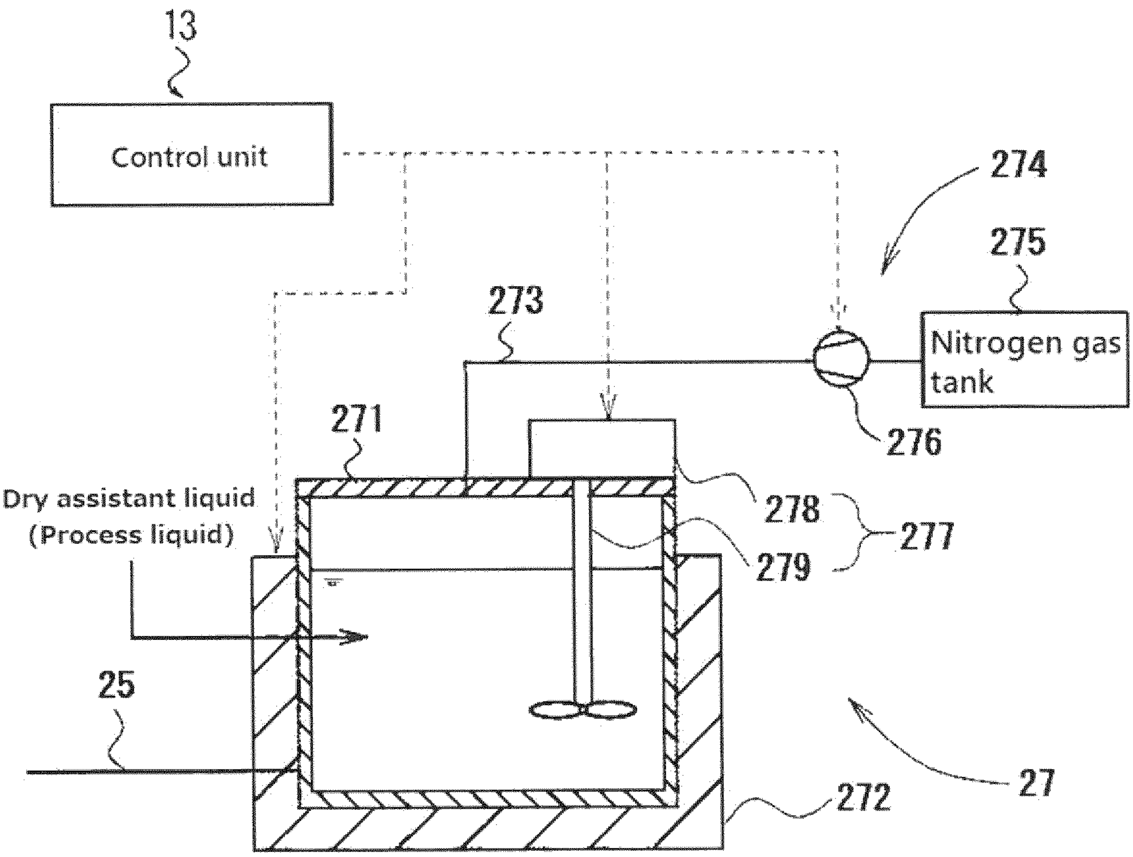
13
Control unit
274
275
273
Nitrogen gas tank
271
276
Dry assistant liquid (Process liquid)
278
277
279
25
272
27

F I G. 5

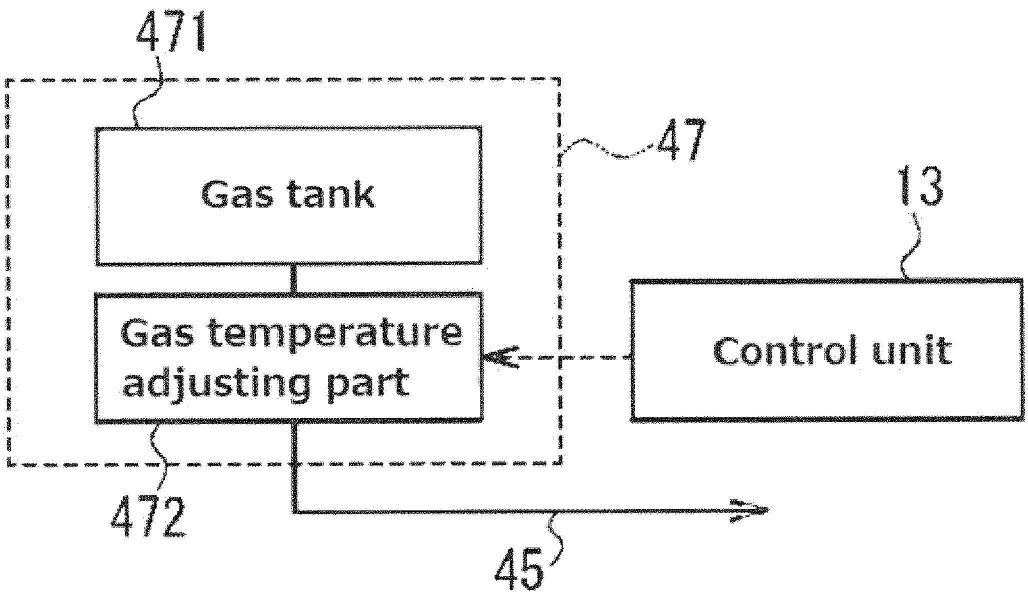
471
47
13
Gas tank
Gas temperature adjusting part
Control unit
472
45

F I G. 6

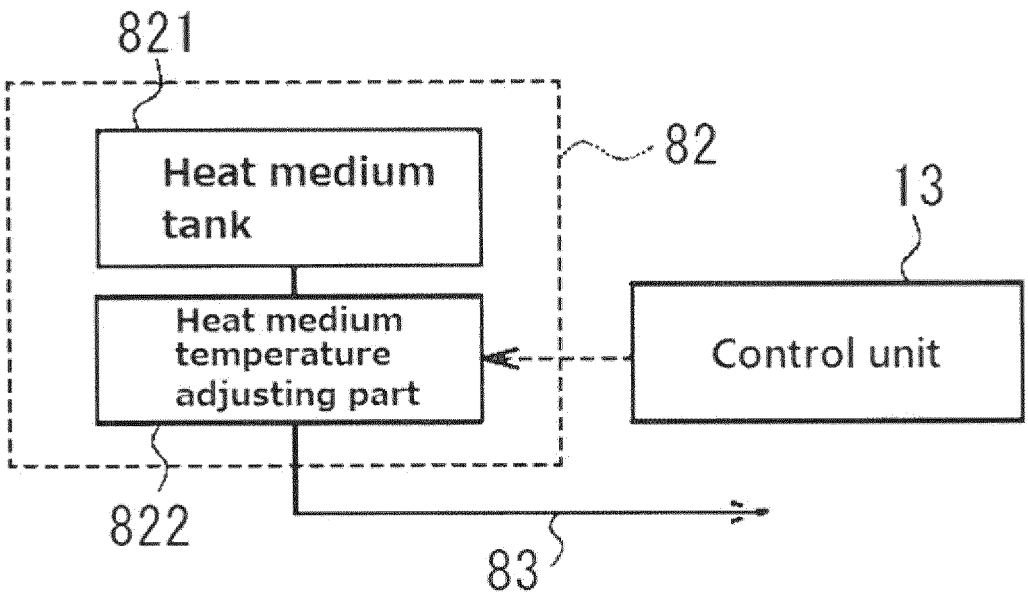
821
82
13
Heat medium tank
Heat medium temperature adjusting part
Control unit
822
83

F I G. 7

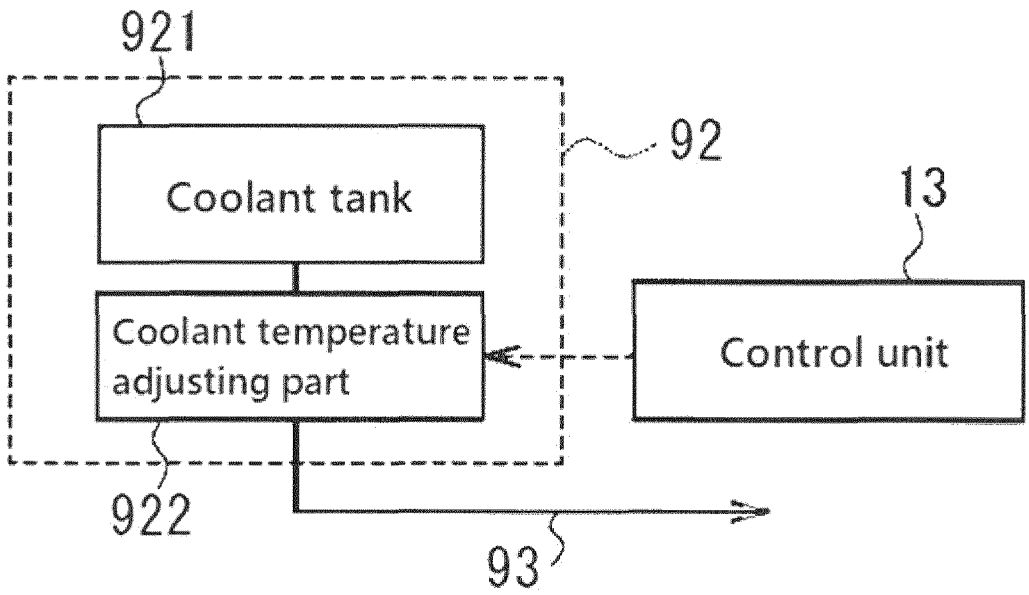
921
92
13
Coolant tank
Coolant temperature adjusting part
Control unit
922
93

F I G. 8

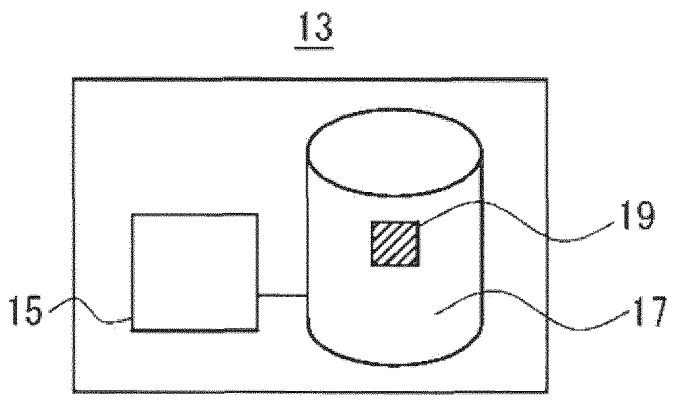
13
19
15
17

F I G. 9

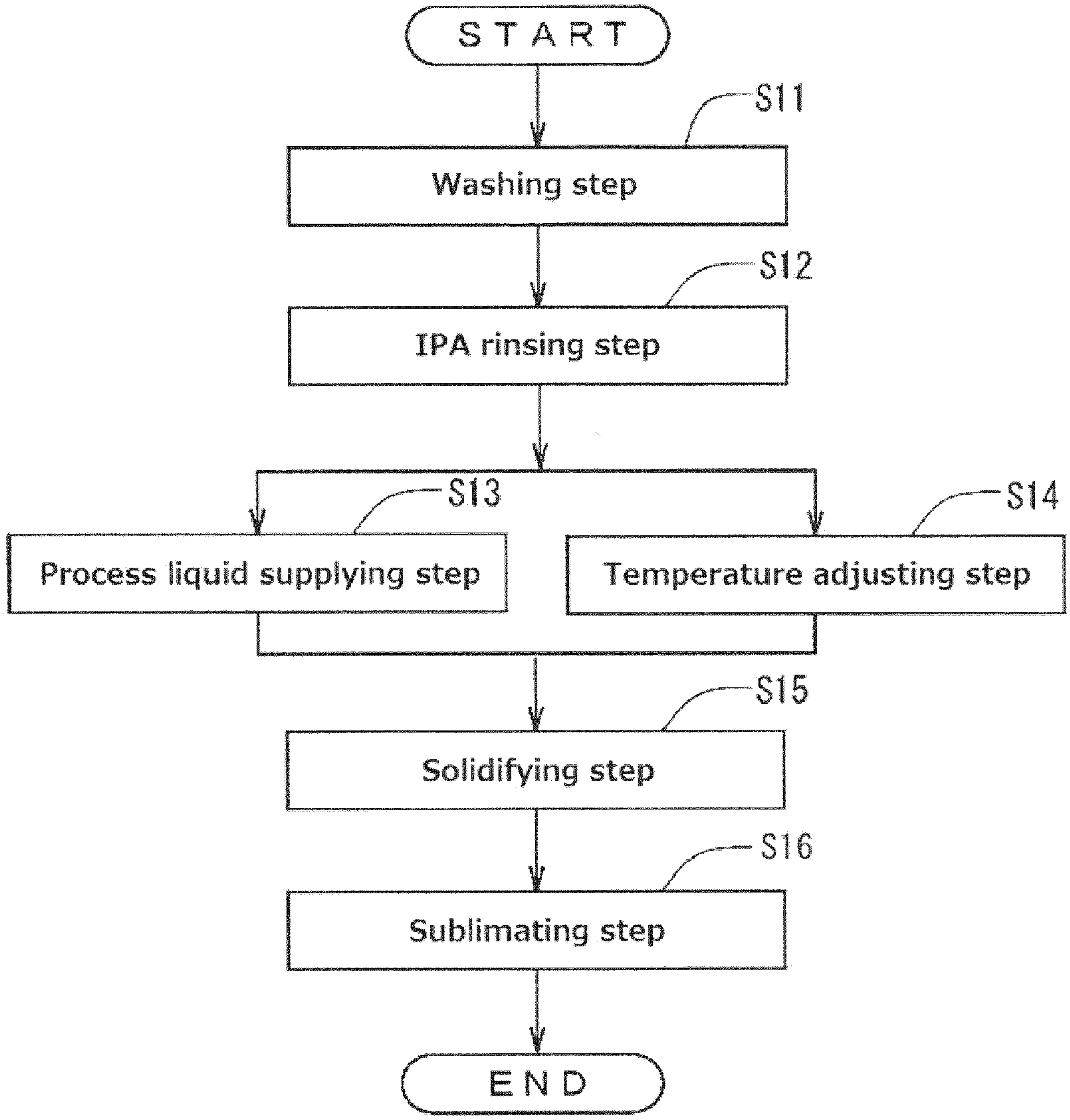
START
S11
Washing step
S12
IPA rinsing step
S13
Process liquid supplying step
S14
Temperature adjusting step
S15
Solidifying step
S16
Sublimating step
END

FIG. 10

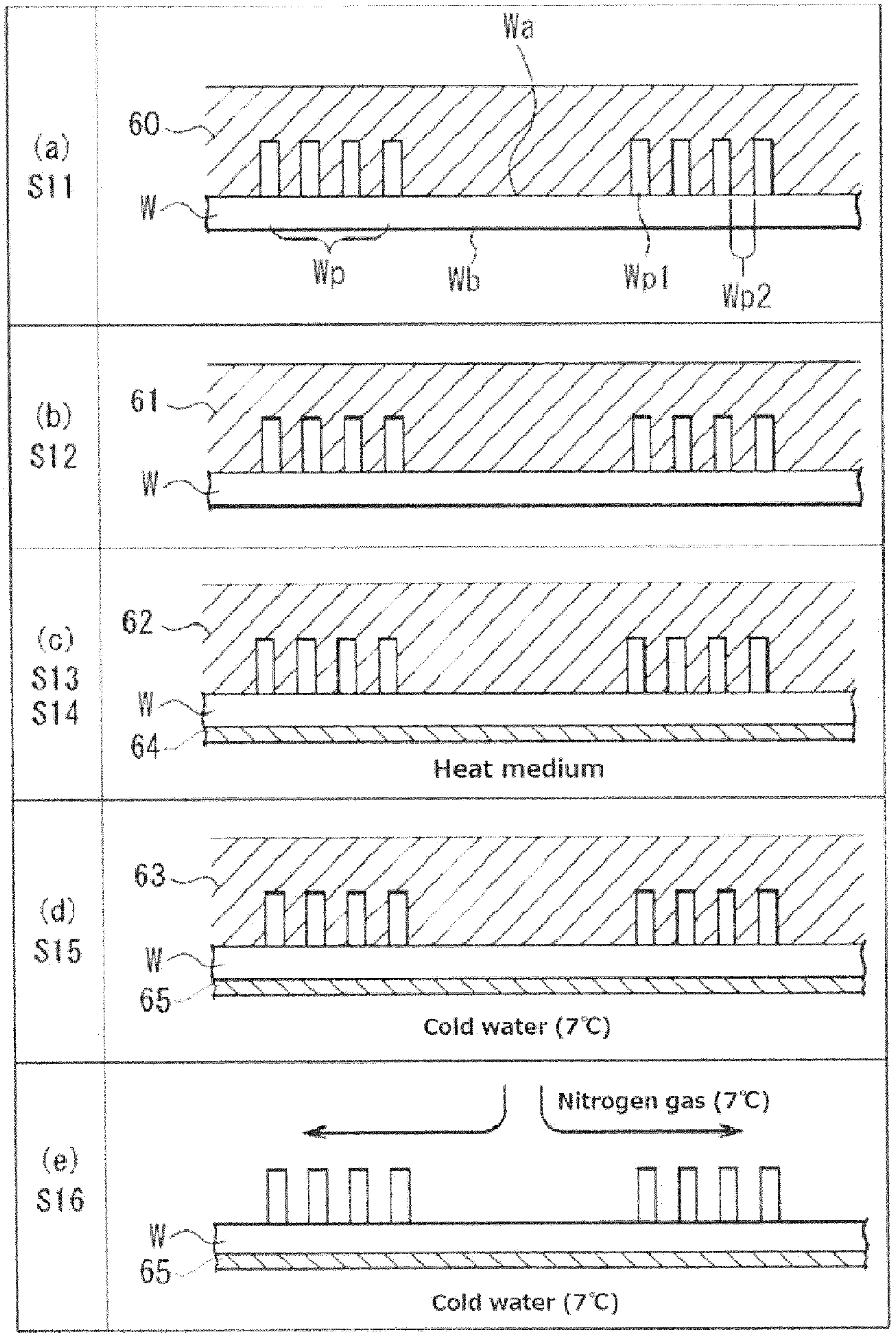

(a)
S11
Wa
60
W
Wp
Wb
Wp1
Wp2
(b)
S12
61
W
(c)
S13
S14
62
W
64
Heat medium
(d)
S15
63
W
65
Cold water (7℃)
(e)
S16
Nitrogen gas (7℃)
W
65
Cold water (7℃)

FIG. 11A

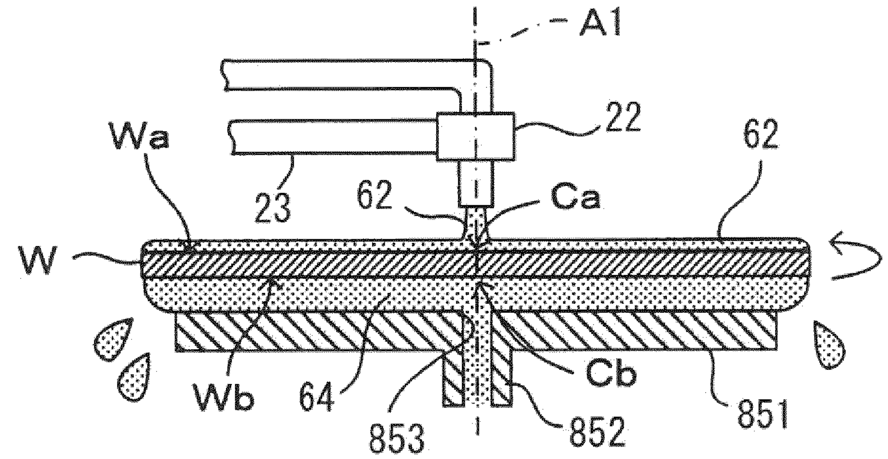


FIG. 11B

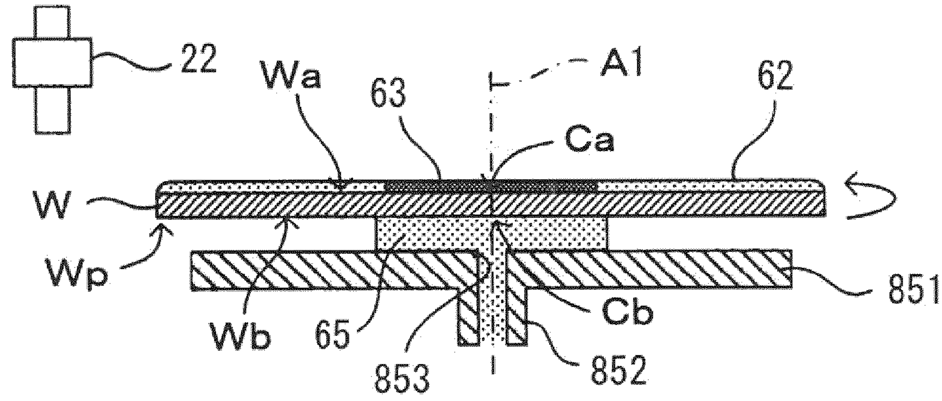


FIG. 11C

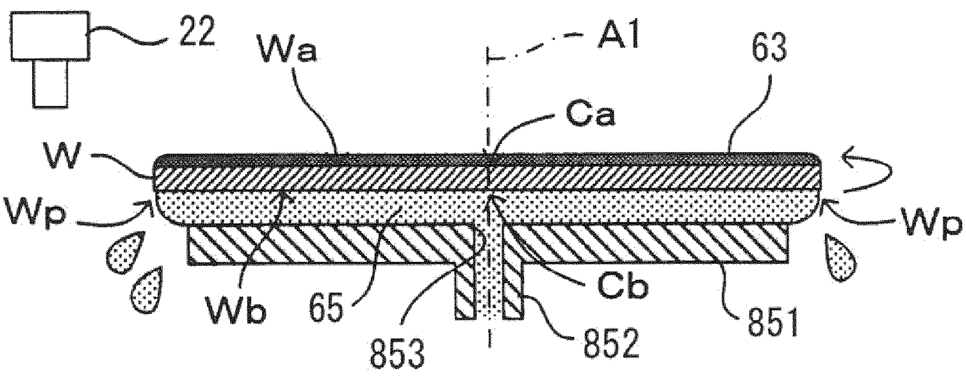

FIG. 12

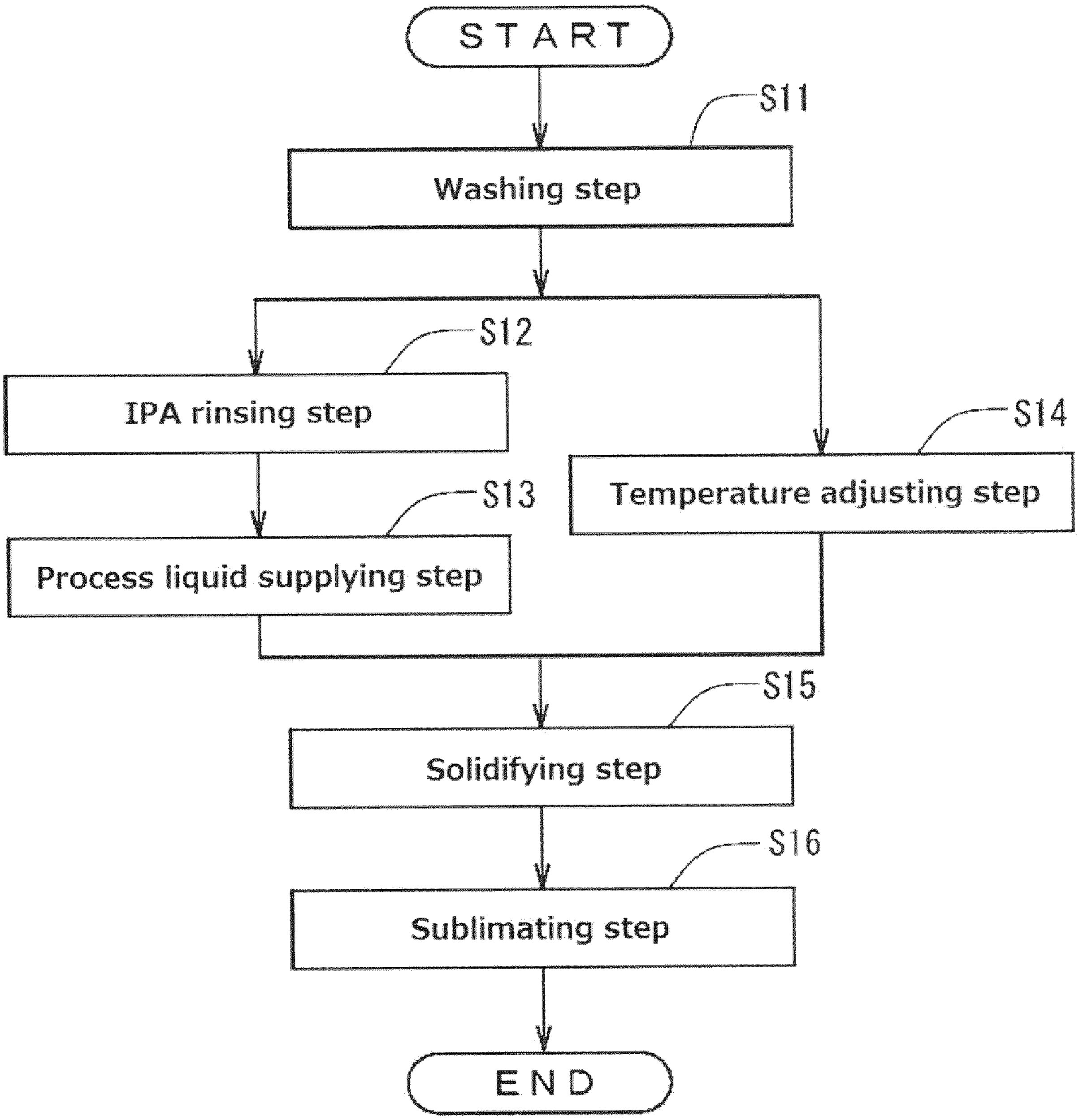
START
S11
Washing step
S12
IPA rinsing step
S13
Process liquid supplying step
S14
Temperature adjusting step
S15
Solidifying step
S16
Sublimating step
END

FIG. 13

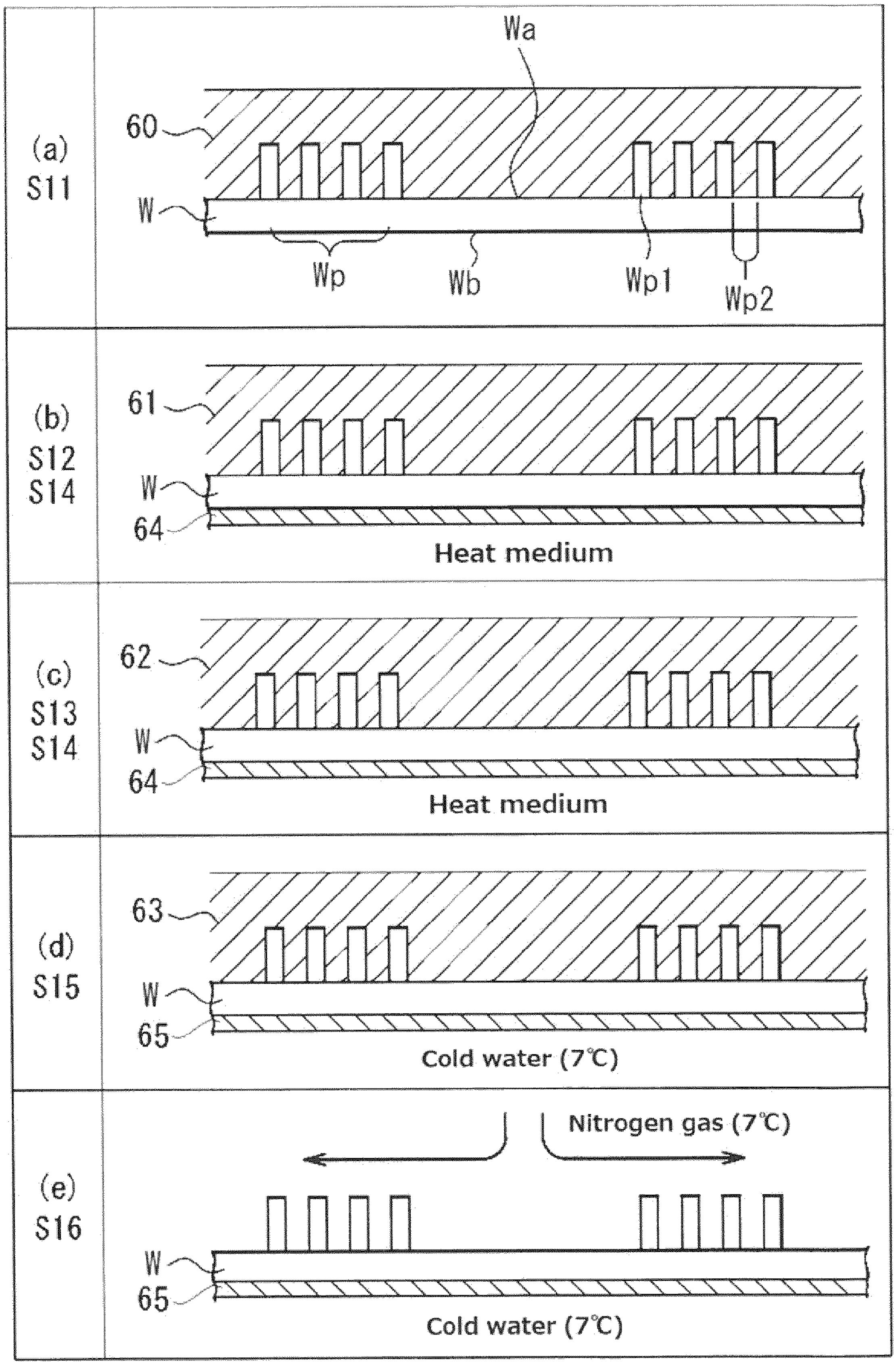
(a)
S11
Wa
60
W
Wp
Wb
Wp1
Wp2
(b)
S12
S14
61
W
64
Heat medium
(c)
S13
S14
62
W
64
Heat medium
(d)
S15
63
W
65
Cold water (7℃)
(e)
S16
Nitrogen gas (7℃)
W
65
Cold water (7℃)

FIG. 14

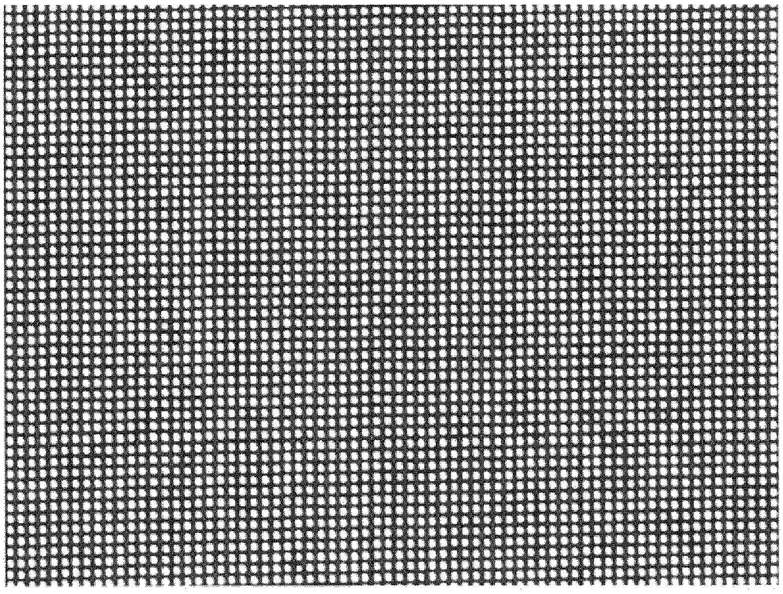

FIG. 15

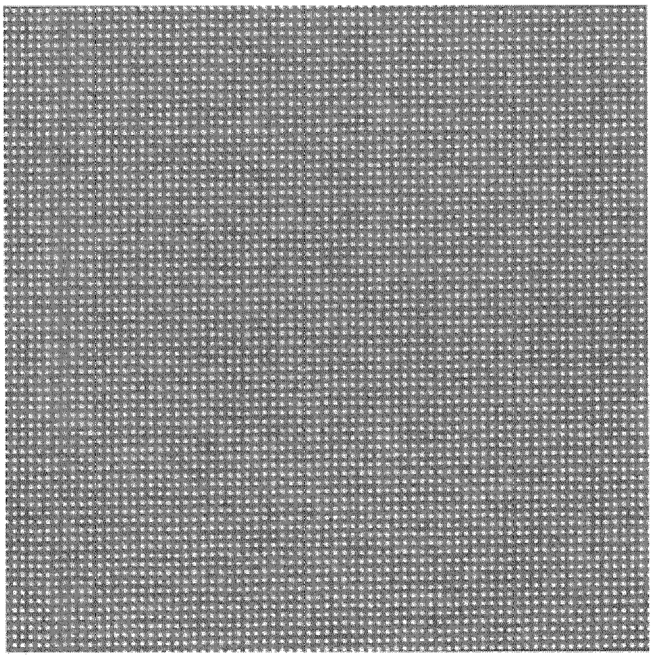

Europäisches Patentamt
European Patent Office
Office européen des brevets

# EUROPEAN SEARCH REPORT

Application Number
EP 18 18 4897

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2014 011426 A (DAINIPPON SCREEN MFG) 20 January 2014 (2014-01-20)<br>* paragraphs [0021] - [0037]; figures 2,3 *<br>* paragraphs [0038] - [0049]; figures 4,5 *<br>----- | 1,2,4-7, 9 | INV.<br>H01L21/02<br>H01L21/67 |
| X | JP 2013 033817 A (TOKYO ELECTRON LTD) 14 February 2013 (2013-02-14)<br>* paragraphs [0011], [0013] - [0024]; figures 1-3 *<br>* paragraphs [0031] - [0049], [0065], [0069]; figures 6-14 *<br>----- | 1-7,9 | |
| X | JP 2013 042094 A (CENTRAL GLASS CO LTD) 28 February 2013 (2013-02-28)<br>* paragraphs [0012], [0034], [0036], [0041] - [0055]; examples 1-9 *<br>----- | 1-9 | |
| X<br>A | US 2016/365240 A1 (SUGITA TOMOHIKO [JP] ET AL) 15 December 2016 (2016-12-15)<br>* paragraphs [0012] - [0035]; figures 2A-3B *<br>* paragraphs [0036] - [0049]; figure 6 *<br>----- | 9<br>3-5 | TECHNICAL FIELDS SEARCHED (IPC)<br>H01L |
| X<br>A | JP 2017 041658 A (TOKYO ELECTRON LTD) 23 February 2017 (2017-02-23)<br>* paragraphs [0038] - [0057]; figure 3 *<br>* paragraphs [0101] - [0128]; figure 7 *<br>----- | 9<br>3-5 | |
| X<br>A | US 2013/068257 A1 (TOMITA HIROSHI [JP] ET AL) 21 March 2013 (2013-03-21)<br>* paragraphs [0028] - [0037], [0042], [0044]; figure 7 *<br>----- | 9<br>3-5 | |

The present search report has been drawn up for all claims

2

| Place of search | Date of completion of the search | Examiner |
|---|---|---|
| The Hague | 19 November 2018 | Szarowski, Anne |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 18 18 4897

This annex lists the patent family members relating to the patent documents cited in the above-mentioned European search report.
The members are as contained in the European Patent Office EDP file on
The European Patent Office is in no way liable for these particulars which are merely given for the purpose of information.

19-11-2018

| Patent document cited in search report | Publication date | Patent family member(s) | Publication date |
|---|---|---|---|
| JP 2014011426 A | 20-01-2014 | JP 6022829 B2 | 09-11-2016 |
| | | JP 2014011426 A | 20-01-2014 |
| JP 2013033817 A | 14-02-2013 | NONE | |
| JP 2013042094 A | 28-02-2013 | NONE | |
| US 2016365240 A1 | 15-12-2016 | JP 2017005134 A | 05-01-2017 |
| | | US 2016365240 A1 | 15-12-2016 |
| JP 2017041658 A | 23-02-2017 | JP 6054343 B2 | 27-12-2016 |
| | | JP 6378294 B2 | 22-08-2018 |
| | | JP 2014197717 A | 16-10-2014 |
| | | JP 2017041658 A | 23-02-2017 |
| | | JP 2018164115 A | 18-10-2018 |
| US 2013068257 A1 | 21-03-2013 | JP 5639556 B2 | 10-12-2014 |
| | | JP 2013069764 A | 18-04-2013 |
| | | US 2013068257 A1 | 21-03-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013016699 A